# EUROPEAN PATENT APPLICATION

(11) **EP 4 333 597 A2**
(43) Date of publication of application: **06.03.2024**
(21) Application number: 23195272.2
(22) Date of filing: 05.09.2023
(51) Int. Cl.: H10K 59/12, H10K 71/00, H10K 77/10

(54) **DISPLAY DEVICE AND METHOD OF FABRICATING THE SAME**

(30) Priority: 05.09.2022 KR 20220112134; 30.09.2022 KR 20220125469
(71) Applicant: Samsung Display Co., Ltd., Yongin-si, Gyeonggi-do 17113 (KR)
(72) Inventor: MUN, Hyo Young, Giheung-gu, Yongin-si, Gyeonggi-do (KR); UM, Yi Seul, Giheung-gu, Yongin-si, Gyeonggi-do (KR); KIM, Wan Jung, Giheung-gu, Yongin-si, Gyeonggi-do (KR); NAM, Kyung Ah, Giheung-gu, Yongin-si, Gyeonggi-do (KR); PARK, Yong Seung, Giheung-gu, Yongin-si, Gyeonggi-do (KR); YUN, Dae Sang, Giheung-gu, Yongin-si, Gyeonggi-do (KR); LEE, So Young, Giheung-gu, Yongin-si, Gyeonggi-do (KR); LEE, Young Hoon, Giheung-gu, Yongin-si, Gyeonggi-do (KR)
(74) Representative: Dr. Weitzel & Partner

(57) **Abstract**

A display device includes: a substrate comprising an upper surface, a bottom surface facing the upper surface, and a through hole penetrating the upper surface and the bottom surface; and a light emitting element layer on the upper surface of the substrate, wherein the substrate comprises a side surface that meets the upper surface in the through hole, a first surface that meets the bottom surface, a second surface that meets the side surface, and a third surface between the first surface and the second surface, and wherein the first surface and the second surface are spaced apart from each other with the third surface therebetween, and are inclined surfaces.

## Description

### BACKGROUND

### 1. Field

Aspects of some embodiments of the present disclosure relate to a display device and a method of fabricating the same.

### 2. Description of the Related Art

As the information-oriented society evolves, demands for display devices are ever increasing. For example, display devices are being employed by a variety of electronic devices such as smart phones, digital cameras, laptop computers, navigation devices, and smart televisions. Display devices may be flat panel display devices such as liquid-crystal display devices, field emission display devices, and organic light-emitting display devices. Among such flat panel display devices, a light-emitting display device includes a light-emitting element that can emit light on its own, so that each of the pixels of the display panel can emit light by themselves. Accordingly, a light-emitting display device can display images without a backlight unit that supplies light to the display panel.

A display device may include a display area where images are displayed, and a non-display area around the display area. Recently, the width of the non-display area is ever decreasing in order for viewers to get more immersed in the contents displayed on the display area and to increase the aesthetics of the display device.

Incidentally, in the process of fabricating a display device, the display device may be formed by cutting a mother substrate along the plurality of display cells formed thereon. For example, a through hole in a display device, in which optical devices such as a camera is located, may be formed by cutting the display device on the mother substrate. During the process of forming the through-hole, the films in the vicinity of the through hole may be damaged, e.g., delaminated, due to the high heat of the laser. For this reason, there are approaches to reduce damage to such a display device.

The above information disclosed in this Background section is only for enhancement of understanding of the background and therefore the information discussed in this Background section does not necessarily constitute prior art.

### SUMMARY

Aspects of some embodiments of the present disclosure include a display device that may reduce damage to the display device and a method of fabricating the same.

It should be noted that characteristics of embodiments according to the present disclosure are not limited to the above-mentioned characteristics; and other characteristics of the present disclosure will be apparent to those skilled in the art from the following descriptions.

The invention is defined by the independent claims. According to the invention, a display device comprises a substrate comprising an upper surface, a bottom surface facing the upper surface, and a through hole penetrating the upper surface and the bottom surface, and a light emitting element layer on the upper surface of the substrate, wherein the substrate comprises a side surface that meets the upper surface in the through hole, a first surface that meets the bottom surface, a second surface that meets the side surface, and a third surface between the first surface and the second surface, and wherein the first surface and the second surface are spaced apart from each other with the third surface therebetween, and are inclined surfaces.

According to some embodiments, one end of the third surface meets the first surface and an opposite end of the third surface meets the second surface.

According to some embodiments, an angle between the bottom surface and the first surface and an angle between the side surface and the second surface are obtuse angles.

According to some embodiments, an angle between the bottom surface and the first surface is equal to an angle between the side surface and the second surface.

According to some embodiments, an angle between the bottom surface and the first surface is greater than an angle between the side surface and the second surface.

According to some embodiments, the angle between the side surface and the second surface is greater than the angle between the bottom surface and the first surface.

According to some embodiments, a length of the first surface in an inclined direction is equal to a length of the second surface in an inclined direction.

According to some embodiments, a length of the first surface in an inclined direction is greater than a length of the second surface in an inclined direction.

According to some embodiments, a length of the second surface in an inclined direction is greater than a length of the first surface in an inclined direction.

According to some embodiments, the third surface is extended in parallel to the bottom surface or the upper surface.

According to some embodiments, the third surface is an inclined surface.

According to some embodiments, at least one of the first surface or the second surface is a straight surface or a curved surface.

According to some embodiments, a length on a plane formed by the first surface, the second surface and the third surface between the bottom surface and the side surface is 100 µm to 500 µm.

According to some embodiments of the present disclosure, a display device comprises a substrate comprising an upper surface, a bottom surface facing the upper surface, and a through hole penetrating the upper surface and the bottom surface, and a light emitting element layer on the upper surface of the substrate, wherein the substrate comprises a side surface that meets the upper surface in the through hole, a first surface that meets the bottom surface, a second surface that meets the side surface, and a third surface between the first surface and the second surface, wherein an angle between the bottom surface and the first surface and an angle between the side surface and the second surface are obtuse angles, and wherein the bottom surface and the third surface form a stepped edge.

According to some embodiments, the angle between the bottom surface and the first surface is greater than the angle between the side surface and the second surface.

According to some embodiments, a length of the first surface in an inclined direction is greater than a length of the second surface in an inclined direction.

According to some embodiments, a length on a plane formed by the first surface, the second surface and the third surface between the bottom surface and the side surface is 100 µm to 500 µm.

According to some embodiments, the display device further comprises an optical device at least partially inserted into the through hole.

According to the invention, a method of fabricating a display device, the method comprises forming a plurality of display cells on a first surface of a mother substrate, forming first laser irradiation areas for cutting the plurality of display cells by irradiating a first laser on a second surface facing the first surface of the mother substrate, irradiating a second laser and a third laser on the first surface of the mother substrate to form second laser irradiation areas and third laser irradiation areas along an edge of a through hole of each of the plurality of display cells, and separating the plurality of display cells by spraying an etchant on the second surface of the mother substrate and cutting the mother substrate along the first laser irradiation areas and the second laser irradiation areas of the mother substrate.

According to some embodiments, the third laser irradiation areas are formed to surround the second laser irradiation areas.

According to some embodiments, a depth of the second laser irradiation areas from the first surface of the mother substrate is greater than a depth of the third laser irradiation areas from the first surface of the mother substrate.

According to some embodiments, a repetition rate of the first laser and the third laser ranges from 10 kHz to 250 kHz, and a repetition rate of the second laser ranges from 1 kHz to 50 kHz.

According to some embodiments, a processing speed of the first laser and the third laser ranges from 10 mm/s to 250 mm/s, and a processing speed of the second laser ranges from 1 mm/s to 50 mm/s.

According to some embodiments, a pulse energy of the first laser and the third laser and a pulse energy of the second laser range from 10 µJ to 300 µJ.

According to some embodiments, the method further comprises forming fourth laser irradiation areas by irradiating a fourth laser along an edge of the through hole at locations spaced apart from and on an inner side of the second laser irradiation areas.

According to some embodiments of the present disclosure, by way of irradiating a laser and then spraying an etchant, it may be possible to reduce the thickness of the mother substrate, to separate each of the plurality of display cells from the mother substrate, and to form a through hollow. In this manner, it may be possible to increase the efficiency of the fabrication process.

In addition, the impact resistance of the substrate can be improved by reducing the angle of the edge of the side surface of the substrate in the through hole of the display device.

In addition, the substrate can be relatively easily separated from the mother substrate at the through hole of the display device, thereby preventing or reducing damage to the substrate.

In addition, it may be possible to prevent or reduce damage to the vicinity of the through hole of the display device due to the high heat of the laser.

It should be noted that characteristics of embodiments according to the present disclosure are not limited to those described above and other effects of the present disclosure will be apparent to those skilled in the art from the following descriptions.

### BRIEF DESCRIPTION OF THE DRAWINGS

The patent or application file contains at least one drawing executed in color. Copies of this patent or patent application publication with color drawing(s) will be provided by the Office upon request and payment of the necessary fee.

The above and other aspects and features of embodiments according to the present disclosure will become more apparent by describing in more detail aspects of some embodiments thereof with reference to the attached drawings, in which:
FIG. 1 is a perspective view of a display device according to some embodiments of the present disclosure.
FIG. 2 is a plan view showing a display panel according to some embodiments of the present disclosure.
FIG. 3 is a cross-sectional view showing an example of the display device taken along the line I - I' of FIG. 1.
FIG. 4 is a cross-sectional view showing an example of the display pixel of FIG. 3 when the circuit board is bent.
FIG. 5 is a cross-sectional view showing an example of the display area of the display panel according to some embodiments of the present disclosure.
FIG. 6 is a layout diagram showing an example of the area A of FIG. 2 in more detail.
FIG. 7 is a layout diagram showing an example of the area B of FIG. 2 in more detail.
FIG. 8 is a layout diagram showing an example of the area D of FIG. 2 in more detail.
FIG. 9 is a cross-sectional view showing an example of a display panel taken along the line II - II' of FIG. 6.
FIG. 10 is a cross-sectional view showing an example of the display panel taken along the line III - III' of FIG. 7.
FIG. 11 is a cross-sectional view showing an example of the display panel, taken along the line IV - IV' of FIG. 8.
FIG. 12 is an enlarged, cross-sectional view showing in more detail an example of the area E of FIG. 9.
FIG. 13 is an enlarged, cross-sectional view showing in more detail an example of the area F of FIG. 10.
FIG. 14 is an enlarged, cross-sectional view showing in more detail an example of the area G of FIG. 11.
FIG. 15 is a layout diagram showing an example of a through hole, an inorganic encapsulation area, a wiring area and a display area of a display panel according to some embodiments.
FIG. 16 is a cross-sectional view showing an example of the display panel taken along the line V - V' of FIG. 15.
FIG. 17 is an enlarged, cross-sectional view showing in more detail examples of the area K of FIG. 15.
FIGS. 18 to 22 are enlarged cross-sectional views showing a variety of examples of the area L of FIG. 15.
FIG. 23 is a flowchart for illustrating a method of fabricating a display device according to some embodiments of the present disclosure.
FIGS. 24 to 38 are views for illustrating the method of fabricating a display device according to some embodiments of the present disclosure.
FIGS. 40 to 42 are cross-sectional views for illustrating a method of fabricating a display device according to some embodiments of the present disclosure.
FIG. 43 is an image showing a through hole of a display device according to Comparative Example.
FIG. 44 is an image showing a through hole of a display device according to some embodiments of the present disclosure.

### DETAILED DESCRIPTION

The present disclosure will now be described more fully hereinafter with reference to the accompanying drawings, in which aspects of some embodiments of the invention are shown. This invention may, however, be embodied in different forms and should not be construed as limited to the embodiments set forth herein. Rather, these embodiments are provided so that this disclosure will be thorough and complete, and will filly convey the scope of the invention to those skilled in the art.

It will also be understood that when a layer is referred to as being "on" another layer or substrate, it can be directly on the other layer or substrate, or intervening layers may also be present. The same reference numbers indicate the same components throughout the specification.

It will be understood that, although the terms "first," "second," etc. may be used herein to describe various elements, these elements should not be limited by these terms. These terms are only used to distinguish one element from another element. For instance, a first element discussed below could be termed a second element without departing from the teachings of the present disclosure. Similarly, the second element could also be termed the first element.

Each of the features of the various embodiments of the present disclosure may be combined or combined with each other, in part or in whole, and technically various interlocking and driving are possible. Each embodiment may be implemented independently of each other or may be implemented together in an association.

Hereinafter, aspects of some embodiments of the present disclosure will be described in more detail with reference to the accompanying drawings.

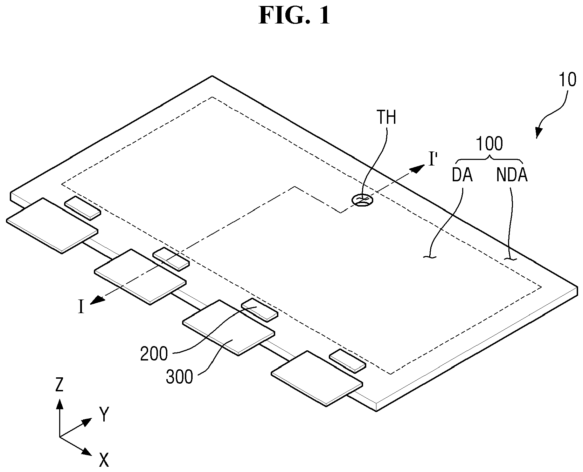

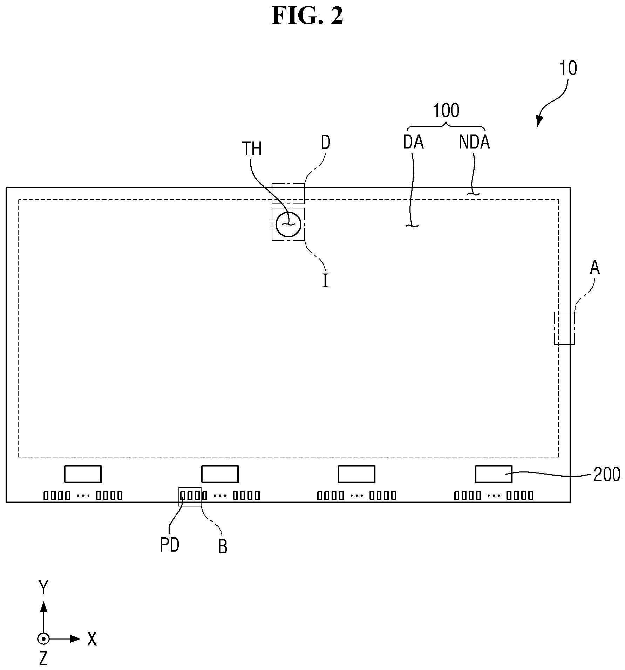

FIG. 1 is a perspective view of a display device according to some embodiments of the present disclosure. FIG. 2 is a plan view showing a display panel according to some embodiments of the present disclosure.

Referring to FIGS. 1 to 2, a display device 10 according to some embodiments of the present disclosure is for displaying moving images or still images. The display device 1 may be used as the display screen of portable electronic devices such as a mobile phone, a smart phone, a tablet PC, a smart watch, a watch phone, a mobile communications terminal, an electronic notebook, an electronic book, a portable multimedia player (PMP), a navigation device and a ultra mobile PC (UMPC), as well as the display screen of various products such as a television, a notebook, a monitor, a billboard and the Internet of Things device.

According to some embodiments of the present disclosure, the display device 10 may be a light-emitting display device such as an organic light-emitting display device using organic light-emitting diodes, a quantum-dot light-emitting display device including quantum-dot light-emitting layer, an inorganic light-emitting display device including an inorganic semiconductor, and a micro-LED display device using micro or nano light-emitting diodes (micro LEDs or nano LEDs). In the following description, an organic light-emitting display device is described as an example of the display device 10. It is, however, to be understood that embodiments according to the present disclosure are not limited thereto.

The display device 10 according to some embodiments includes a display panel 100, a driving integrated circuit (IC) 200, and a circuit board 300.

The display panel 100 may be formed in a rectangular plane having longer sides in a first direction (x-axis direction) and shorter sides in a second direction (y-axis direction) intersecting the first direction (x-axis direction). Each of the corners where the longer side in the first direction (x-axis direction) meets the shorter side in the second direction (y-axis direction) may be formed at a right angle or may be rounded with a curvature. The shape of the display panel 100 when viewed from the top is not limited to a quadrangular shape, but may be formed in a different polygonal shape, a circular shape, or an elliptical shape.

The display panel 100 may be formed flat, but is not limited thereto. For example, the display panel 100 may be formed at left and right ends, and may include a curved portion having a constant curvature or a varying curvature. In addition, the display panel 100 may be flexible so that it can be curved, bent, folded or rolled.

The display panel 100 may include a display area DA where images are displayed, and a non-display area NDA arranged around (e.g., in a peripheral area, or outside a footprint of) the display area DA.

The display area DA may occupy most of the area of the display panel 100. The display area DA may be located at the center of display device 100. In the display area DA, pixels each including a plurality of emission areas may be formed to display images.

The non-display area NDA may be located adjacent to the display area DA (e.g., outside a footprint of the display area DA, or in a periphery of the display area DA). The non-display area NDA may be located on the outer side of the display area DA. The non-display area NDA may surround the display area DA. The non-display area NDA may be defined as the border of the display panel 100.

In the non-display area NDA, display pads DP may be arranged to be connected to the circuit boards 300. The display pads DP may be located at one edge of the display panel 100. For example, the display pads DP may be located at the lower edge of the display panel 100.

The driving integrated circuits (ICs) 200 may generate data voltages, supply voltages, scan timing signals, etc. The driving ICs 200 may output data voltages, supply voltages, scan timing signals, etc.

The driving ICs 200 may be located between the display pads PD and the display area DA in the non-display area NDA. Each of the driving ICs 200 may be attached to the non-display area NDA of the display panel 100 by a chip on glass (COG) technique. Alternatively, the driving ICs 200 may be attached to the circuit boards 300, respectively, by a chip on plastic (COP) technique.

The circuit boards 300 may be located on the display pads DP located at one edge of the display panel 100. The circuit boards 300 may be attached to the display pads PD using a conductive adhesive member such as an anisotropic conductive film and an anisotropic conductive adhesive. Accordingly, the circuit boards 300 may be electrically connected to signal lines of the display panel 100. The circuit boards 300 may be flexible printed circuit boards, flexible films such as chip on films.

A bending area BA may be located between the driving ICs 200 and the display area DA in the non-display area NDA. The bending area BA may be bent such that the driving ICs 200 and the circuit boards 300 are located under a substrate SUB.

A through hole TH may be formed at one side of the display area DA. The through hole TH can transmit light, in which an optical device may be located.

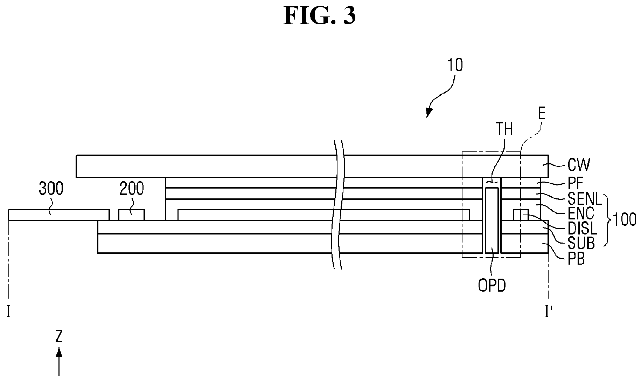

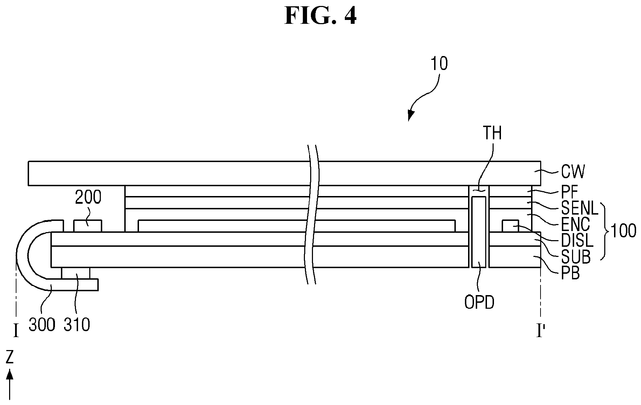

FIG. 3 is a cross-sectional view showing an example of the display device taken along the line I - I' of FIG. 1. FIG. 4 is a cross-sectional view showing an example of the display pixel of FIG. 3 when the circuit board is bent. Referring to FIG. 3, the display device 10 according to some embodiments may include a display panel 100, a polarizing film PF, a cover window CW, and a panel bottom cover PB. The display panel 100 may include a substrate SUB, a display layer DISL, an encapsulation layer ENC, and a sensor electrode layer SENL.

The substrate SUB is a rigid substrate, and may be, for example, a glass substrate.

The display layer DISL may be located on a first surface of the substrate SUB. The display layer DISL may display images. The display layer DISL may include a thin-film transistor layer TFTL (see FIG. 4) in which thin-film transistors are formed, and a light emitting element layer EML (see FIG. 4) in which light-emitting elements that emit light are located in the emission areas.

In the display area DA of the display layer DISL, scan lines, data lines, voltage lines, etc. may be arranged so that lights are emitted in the emission areas. In the non-display area NDA of the display layer DISL, a scan driver circuit outputting scan signals to the scan lines, fan-out lines connecting the data lines with the driving ICs 200, etc. may be arranged.

The encapsulation layer ENC may encapsulate the light emitting element layer of the display layer DISL to prevent or reduce instances of oxygen or moisture permeating into the light emitting element layer of the display layer DISL. The encapsulation layer ENC may be located on the display layer DISL. The encapsulation layer ENC may be located on the upper and side surfaces of the display layer DISL. The encapsulation layer ENC may be arranged to cover the display layer DISL.

The sensor electrode layer SENL may be located on the display layer DISL. The sensor electrode layer SENL may include sensor electrodes. The sensor electrode layer SENL can sense a user's touch using the sensor electrodes.

The polarizing film PF may be located on the sensor electrode layer SENL. The polarizing film PF may be located on the display panel 100 in order to reduce reflection of external light. The polarizing film PF may include a first base member, a linear polarizer, a retardation film such as a λ/4 (quarter-wave) plate, and a second base member. The first base member, the retardation film, the linear polarizer and the second base member of the polarizing film PF may be sequentially stacked on the display panel 100.

The cover window CW may be located on the polarizing film PF. The cover window CW may be attached onto the polarizing film PF by a transparent adhesive member such as an optically clear adhesive (OCA) film.

The panel bottom cover PB may be located on a second surface of the substrate SUB of the display panel 100. The second surface of the substrate SUB may be opposite to the first surface. The panel bottom cover PB may be attached to the second surface of the substrate SUB of the display panel 100 by an adhesive member. The adhesive member may be a pressure-sensitive adhesive (PSA).

The panel bottom cover PB may include at least one of: a light-blocking member for absorbing light incident from outside, a buffer member for absorbing external impact, or a heat dissipating member for efficiently discharging heat from the display panel 100.

The light-blocking member may be located under the display panel 100. The light-blocking member blocks the transmission of light to prevent or reduce instances of the elements located thereunder being seen from above the display panel 100, such as the display circuit board 300. The light-blocking member may include a light-absorbing material such as a black pigment and a black dye.

The buffer member may be located under the light-blocking member. The buffer member absorbs an external impact to prevent or reduce damage to the display panel 100. The buffer member may be made up of a single layer or multiple layers. For example, the buffer member may be formed of a polymer resin such as polyurethane, polycarbonate, polypropylene and polyethylene, or may be formed of a material having elasticity such as a rubber and a sponge obtained by foaming a urethane-based material or an acrylic-based material.

The heat dissipating member may be located under the buffer member. The heat-dissipating member may include a first heat dissipation layer including graphite or carbon nanotubes, and a second heat dissipation layer formed of a thin metal film such as copper, nickel, ferrite and silver, which can block electromagnetic waves and have high thermal conductivity.

The driving IC 200 and the circuit board 300 may be bent such that they are located under the display panel 100. The circuit board 300 may be attached to the lower surface (or bottom surface) of the panel bottom cover PB by an adhesive member 310. The adhesive member 310 may be a pressure-sensitive adhesive.

A through hole TH may be formed in the display device 10 according to some embodiments. The through hole TH may allow light to pass through it, and may be a physical hole penetrating through the panel bottom cover PB and the polarizing film PF as well as the display panel 100. It should be understood, however, that embodiments according to the present disclosure are not limited thereto. The through hole TH may penetrate through the panel bottom cover PB but may not penetrate through the display panel 100 or the polarizing film PF. The cover window CW may be arranged to cover the through hole TH.

The through hole TH may penetrate through the substrate SUB, the display layer DISL, the encapsulation layer ENC and the sensor electrode layer SENL of the display panel 100. The through hole TH may not penetrate through the cover window CW.

The electronic device including the display device 10 according to some embodiments may further include an optical device OPD located in the through hole TH. The optical device OPD may be spaced apart from the display panel 100, the panel bottom cover PB and the polarizing film PF. The optical device OPD may be an optical sensor that senses light incident through the through hole TH, such as a proximity sensor, an illuminance sensor, and a camera sensor.

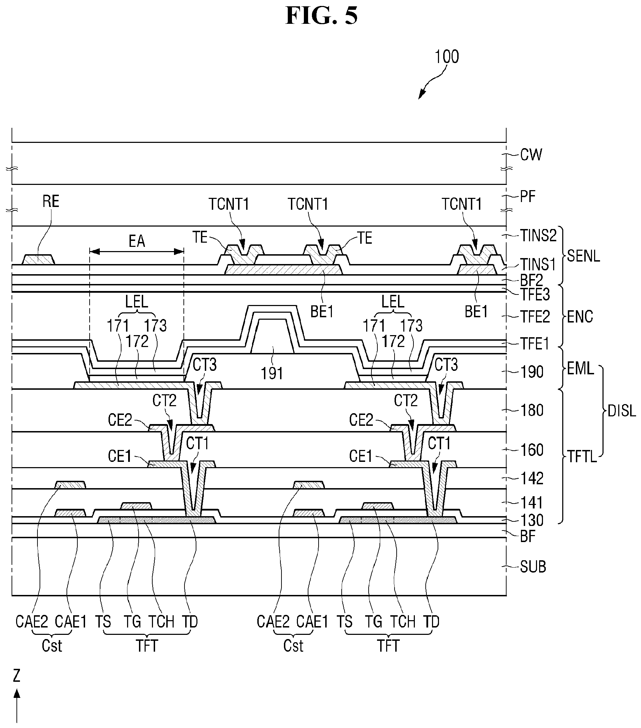

FIG. 5 is a cross-sectional view showing an example of the display area of the display panel according to some embodiments of the present disclosure.

Referring to FIG. 5, the display panel 100 according to some embodiments of the present disclosure may be an organic light-emitting display panel including light-emitting elements LEL each including an organic emissive layer 172.

The display layer DISL may include a thin-film transistor layer TFTL including a plurality of thin-film transistors and a light emitting element layer EML including a plurality of light-emitting elements.

A buffer film BF may be located on the substrate SUB. The buffer film BF may be formed of an inorganic material such as a silicon nitride layer, a silicon oxynitride layer, a silicon oxide layer, a titanium oxide layer, and an aluminum oxide layer. Alternatively, the buffer film BF may be made up of multiple layers in which two or more of a silicon nitride layer, a silicon oxynitride layer, a silicon oxide layer, a titanium oxide layer and an aluminum oxide layer are stacked on one another.

An active layer including a channel region TCH, a source region TS and a drain region TD of the thin-film transistor TFT may be located on the buffer film BF. The active layer may be made of polycrystalline silicon, monocrystalline, low-temperature polycrystalline silicon, amorphous silicon, or an oxide semiconductor. When the active layer includes polycrystalline silicon or an oxide semiconductor material, the source region TS and the drain region TD in the active layer may be conductive regions doped with ions or impurities to have conductivity.

A gate insulator 130 may be located on the active layer of the thin-film transistor TFT. The gate insulator 130 may be formed of an inorganic layer, for example, a silicon nitride layer, a silicon oxynitride layer, a silicon oxide layer, a titanium oxide layer, or an aluminum oxide layer.

A first gate metal layer including a gate electrode TG of the thin-film transistor TFT, a first capacitor electrode CAE1 of a capacitor Cst, and scan lines may be located on the gate insulator 130. The gate electrode G of the thin-film transistor TFT may overlap the channel region TCH in the third direction (z-axis direction). The first gate metal layer may be made up of a single layer or multiple layers of one of molybdenum (Mo), aluminum (Al), chromium (Cr), gold (Au), titanium (Ti), nickel (Ni), neodymium (Nd) and copper (Cu) or an alloy thereof.

The first interlayer dielectric film 141 may be located on the first gate metal layer. The first interlayer dielectric film 141 may be formed of an inorganic layer, for example, a silicon nitride layer, a silicon oxynitride layer, a silicon oxide layer, a titanium oxide layer, or an aluminum oxide layer. The first interlayer dielectric film 141 may include a number of inorganic layers.

The second gate metal layer including a second capacitor electrode CAE2 of the capacitor Cst may be located on the first interlayer dielectric film 141. The second capacitor electrode CAE2 may overlap the first capacitor electrode CAE1 in the third direction (z-axis direction). Therefore, the capacitor Cst may be formed by the first capacitor electrode CAE1, the second capacitor electrode CAE2, and an inorganic insulating dielectric film located therebetween and serving as a dielectric film. The second gate metal layer may be made up of a single layer or multiple layers of one of molybdenum (Mo), aluminum (Al), chromium (Cr), gold (Au), titanium (Ti), nickel (Ni), neodymium (Nd) and copper (Cu) or an alloy thereof.

A second interlayer dielectric film 142 may be located on the second gate metal layer. The second interlayer dielectric film 142 may be formed of an inorganic layer, for example, a silicon nitride layer, a silicon oxynitride layer, a silicon oxide layer, a titanium oxide layer, or an aluminum oxide layer. The second interlayer dielectric film 142 may include a number of inorganic layers.

The first data metal layer including first connection electrodes CE1 and data lines may be located on the second interlayer dielectric film 142. The first connection electrode CE1 may be connected to the drain region TD through a first contact hole CT1 penetrating the gate insulator 130, the first interlayer dielectric film 141 and the second interlayer dielectric film 142. The first data metal layer may be made up of a single layer or multiple layers of one of molybdenum (Mo), aluminum (Al), chromium (Cr), gold (Au), titanium (Ti), nickel (Ni), neodymium (Nd) and copper (Cu) or an alloy thereof.

A first organic film 160 may be arranged over the first connection electrode CE1 for providing a flat surface over the thin-film transistors TFT having uneven heights. The first organic film 160 may be formed as an organic layer such as an acryl resin, an epoxy resin, a phenolic resin, a polyamide resin and a polyimide resin.

A second data metal layer including second connection electrodes CE2 may be located on the first organic film 160. The second data metal layer may be connected to the first connection electrode CE1 through a second contact hole CT2 penetrating the first organic film 160. The second data metal layer may be made up of a single layer or multiple layers of one of molybdenum (Mo), aluminum (Al), chromium (Cr), gold (Au), titanium (Ti), nickel (Ni), neodymium (Nd) and copper (Cu) or an alloy thereof.

The second organic film 180 may be located on the second connection electrode CE2. The second organic film 180 may be formed as an organic layer such as an acryl resin, an epoxy resin, a phenolic resin, a polyamide resin and a polyimide resin.

It should be noted that the second data metal layer including the second connection electrodes CE2 and the second organic film 180 may be eliminated.

The light emitting element layer EML is located on the thin-film transistor layer TFTL. The light emitting element layer EML may include light-emitting elements LEL and a bank 190.

Each of the light-emitting elements LEL may include a pixel electrode 171, an emissive layer 172, and a common electrode 173. In each of the emission areas EA, the pixel electrode 171, the emissive layer 172 and the common electrode 173 are stacked on one another sequentially, so that holes from the pixel electrode 171 and electrons from the common electrode 173 are combined with each other in the emissive layer 172 to emit light. In such case, the pixel electrode 171 may be an anode electrode while the common electrode 173 may be a cathode electrode.

A pixel electrode layer including the pixel electrode 171 may be formed on the second organic film 180. The pixel electrode 171 may be connected to the second connection electrode CE2 through a third contact hole CT3 penetrating the second organic film 180. The pixel electrode layer may be made up of a single layer or multiple layers of one of molybdenum (Mo), aluminum (Al), chromium (Cr), gold (Au), titanium (Ti), nickel (Ni), neodymium (Nd) and copper (Cu) or an alloy thereof.

In the top-emission structure where light exits from the emissive layer 172 toward the common electrode 173, the pixel electrode 171 may be made up of a single layer of molybdenum (Mo), titanium (Ti), copper (Cu) or aluminum (Al), or may be made up of a stack structure of aluminum and titanium (Ti/Al/Ti), a stack structure of aluminum and ITO (ITO/AI/ITO), an APC alloy and a stack structure of APC alloy and ITO (ITO/APC/ITO) in order to increase the reflectivity. The APC alloy is an alloy of silver (Ag), palladium (Pd) and copper (Cu).

The bank 190 may define the emission areas EA of the pixels. To this end, the bank 190 may be formed on the second organic film 180 to expose a portion of the pixel electrode 171. The bank 190 may cover the edge of the pixel electrode 171. The bank 190 may be located inside the third contact hole CT3. In other words, the third contact hole CT3 may be filled with the bank 190. The bank 190 may be formed of an organic layer such as an acryl resin, an epoxy resin, a phenolic resin, a polyamide resin and a polyimide resin.

A spacer 191 may be located on the bank 190. The spacer 191 may support a mask during a process of fabricating the emissive layer 172. The spacer 191 may be formed of an organic layer such as an acryl resin, an epoxy resin, a phenolic resin, a polyamide resin and a polyimide resin.

The emissive layer 172 is formed on the pixel electrode 171. The emissive layer 172 may include an organic material to emit light of a certain color. For example, the emissive layer 172 may include a hole transporting layer, an organic material layer, and an electron transporting layer. The organic material layer may include a host and a dopant. The organic material layer may include a material that emits a predetermined light, and may be formed using a phosphor or a fluorescent material.

The common electrode 173 is formed on the emissive layer 172. The cathode electrode 173 may be formed to cover the emissive layer 172. The common electrode 173 may be a common layer formed across the emission areas EA1, EA2, EA3 and EA4. A capping layer may be formed on the common electrode 173.

In the top-emission structure, the common electrode 173 may be formed of a transparent conductive material (TCP) such as ITO and IZO that can transmit light, or a semi-transmissive conductive material such as magnesium (Mg), silver (Ag) and an alloy of magnesium (Mg) and silver (Ag). When the common electrode 173 is formed of a semi-transmissive metal material, the light extraction efficiency can be increased by using microcavities.

The encapsulation layer ENC may be located on the light emitting element layer EML. The encapsulation layer ENC may include one or more inorganic films TFE1 and TFE3 to prevent or reduce permeation of oxygen or moisture into the light emitting element layer EML. In addition, the encapsulation layer ENC may include at least one organic film in order to protect the light emitting element layer EML from particles such as dust. For example, the encapsulation layer ENC may include a first inorganic encapsulation film TFE1, an organic encapsulation film TFE2 and a second inorganic encapsulation film TFE3.

The first inorganic encapsulation film TFE1 may be located on the common electrode 173, the organic encapsulation film TFE2 may be located on the first inorganic encapsulation film TFE1, and the second inorganic encapsulation film TFE3 may be located on the organic encapsulation film TFE2. The first inorganic encapsulation film TFE1 and the second inorganic encapsulation film TFE3 may be made up of multiple layers in which one or more inorganic layers of a silicon nitride layer, a silicon oxynitride layer, a silicon oxide layer, a titanium oxide layer and an aluminum oxide layer are alternately stacked on one another. The organic encapsulation film TFE2 may be an organic film such as an acryl resin, an epoxy resin, a phenolic resin, a polyamide resin, a polyimide resin, etc.

The sensor electrode layer SENL may be located on the encapsulation layer ENC. The sensor electrode layer SENL may include sensor electrodes TE and RE.

A second buffer film BF2 may be located on the encapsulation layer ENC. The second buffer film BF2 may include at least one inorganic film. For example, the second buffer film BF2 may be made up of multiple layers in which one or more inorganic layers of a silicon nitride layer, a silicon oxynitride layer, a silicon oxide layer, a titanium oxide layer and an aluminum oxide layer are alternately stacked on one another. The second buffer film BF2 may be eliminated.

First bridges BE1 may be located on the second buffer film BF2. The first bridges BE1 may be made up of a single layer of molybdenum (Mo), titanium (Ti), copper (Cu) or aluminum (Al), or may be made up of a stack structure of aluminum and titanium (Ti/Al/Ti), a stack structure of aluminum and ITO (ITO/AI/ITO), an APC alloy and a stack structure of an APC alloy and ITO (ITO/APC/ITO).

A first sensor insulating film TINS1 may be located on the first bridges BE1. The first sensor insulating film TINS1 may be formed of an inorganic layer, for example, a silicon nitride layer, a silicon oxynitride layer, a silicon oxide layer, a titanium oxide layer, or an aluminum oxide layer.

The sensor electrodes, i.e., driving electrodes TE and sensing electrodes RE may be located on the first sensor insulating film TINS1. In addition, dummy patterns may be located on the first sensor insulating film TNIS1. The driving electrodes TE, the sensing electrodes RE and the dummy patterns do not overlap the emission areas EA. The driving electrodes TE, the sensing electrodes RE and the dummy patterns may be made up of a single layer of molybdenum (Mo), titanium (Ti), copper (Cu) or aluminum (Al), or may be made up of a stack structure of aluminum and titanium (Ti/Al/Ti), a stack structure of aluminum and ITO (ITO/AI/ITO), an APC alloy and a stack structure of an APC alloy and ITO (ITO/APC/ITO).

The second sensor insulating film TINS2 may be located on the driving electrodes TE, the sensing electrodes RE, and the dummy patterns. The second sensor insulating film TINS2 may include at least one of an inorganic film or an organic film. The inorganic film may be a silicon nitride layer, a silicon oxynitride layer, a silicon oxide layer, a titanium oxide layer, or an aluminum oxide layer. The organic film may be an acryl resin, an epoxy resin, a phenolic resin, a polyamide resin and a polyimide resin.

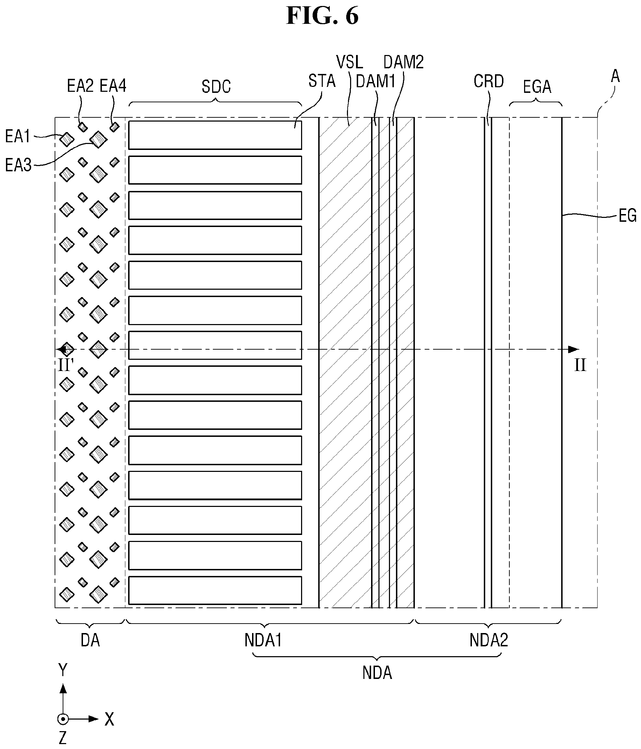

FIG. 6 is a layout diagram showing an example of the area A of FIG. 2 in more detail. FIG. 6 is a layout diagram showing a display area DA and a non-display area NDA located on the right side of the display panel 100 according to some embodiments.

Referring to FIG. 6, the display area DA may include a plurality of emission areas EA1, EA2, EA3 and EA4. The plurality of emission areas EA1, EA2, EA3 and EA4 may include a first emission area EA1 emitting light of a first color, a second emission area EA2 and a fourth emission area EA4 emitting light of a second color, and a third emission area EA3 emitting light of a third color. For example, the light of the first color may be light in a red wavelength range of approximately 600 nm to 750 nm, the light of the second color may be light in a green wavelength range of approximately 480 nm to 560 nm, and the light of the third color may be light in a blue wavelength range of approximately 370 nm to 460 nm. It should be understood, however, that the present disclosure is not limited thereto.

Although the second emission area EA2 and the fourth emission area EA4 emit light of the same color, i.e., the light of the second color in the example shown in FIG. 6, the embodiments of the present disclosure are not limited thereto. The second emission area EA2 and the fourth emission area EA4 may emit lights of different colors. For example, the second emission area EA2 may emit light of the second color, and the fourth emission area EA4 may emit light of a fourth color.

In addition, although each of the first emission areas EA1, the second emission areas EA2, the third emission areas EA3 and the fourth emission areas EA4 may have a rectangular shape when viewed from the top in the example shown in FIG. 6, the embodiments of the present disclosure are not limited thereto. Each of the first emission areas EA1, the second emission areas EA2, the third emission areas EA3 and the fourth emission areas EA4 may have other polygonal shape than a quadrangular shape, a circular shape, or an elliptical shape when viewed from the top.

In addition, as shown in FIG. 6, the third emission area EA3 may be the largest, while the second emission area EA2 and the fourth emission area EA4 may be the smallest. The third emission area EA3 and the fourth emission area EA4 may have the same size.

The second emission areas EA2 and the fourth emission areas EA4 may be arranged alternately in the first direction (x-axis direction). The second emission areas EA2 may be arranged in the second direction (y-axis direction). The fourth emission areas EA4 may be arranged in the second direction (y-axis direction). Each of the fourth emission areas EA4 may have longer sides in a first diagonal direction DD1 and shorter sides in a second diagonal direction DD2, while each of the second emission areas EA2 may have longer sides in the second diagonal direction DD2 and shorter sides in the first diagonal direction DD2. The first diagonal direction DD1 may refer to a diagonal direction between the first direction (x-axis direction) and the second direction (y-axis direction), and the second diagonal direction DD2 may be perpendicular to the first diagonal direction DD1.

The first emission areas EA1 and the third emission areas EA3 may be arranged alternately in the first direction (x-axis direction). The first emission areas EA1 may be arranged in the second direction (y-axis direction). The third emission areas EA3 may be arranged in the second direction (y-axis direction). Each of the first emission areas EA1 and the third emission areas EA3 may have a square shape when viewed from the top, but embodiments of the present disclosure are not limited thereto. In this instance, each of the first emission areas EA1 and the third emission areas EA3 may include two sides parallel to each other in the first diagonal direction DD1 and two sides parallel to each other in the second diagonal direction DD2.

The non-display area NDA may include a first non-display area NDA1 and a second non-display area NDA2. In the first non-display area NDA1, structures for driving pixels of the display area DA may be located. The second non-display area NDA2 may be located on the outer side of the first non-display area NDA1. The second non-display area NDA2 may be an edge area of the non-display area NDA. In addition, the second non-display area NDA2 may be an edge area of the display panel 100.

The first non-display area NDA1 may include a scan driving circuit SDC, a first supply voltage line VSL, a first dam DAM1 and a second dam DAM2.

The scan driving circuit SDC may include a plurality of stages STA. The plurality of stages STA may be respectively connected to the scan lines SL of the display area DA extended in the first direction (x-axis direction). That is to say, the plurality of stages STA may be connected to the scan lines SL of the display area DA extended in the first direction (x-axis direction), respectively. The stages STA may sequentially apply scan signals to the scan lines SL.

The first supply voltage line VSL may be located on the outer side of the scan driving circuit SDC. That is to say, the first supply voltage line VSL may be located closer to an edge EG of the display panel 100 than the scan driving circuit SDC is. The first supply voltage line VSL may be extended in the second direction (y-axis direction) in the non-display area NDA on the left side of the display panel 100.

The first supply voltage line VSL may be electrically connected to the common electrode 173, and accordingly the common electrode 173 may receive a first supply voltage from the first supply voltage line VSL.

The first dam DAM1 and the second dam DAM2 are structures for preventing or reducing instances of the organic encapsulation film TFE2 of the encapsulation layer ENC overflowing to the edge EG of the display panel 100. The first dam DAM1 and the second dam DAM2 may be extended in the second direction (y-axis direction) in the non-display area NDA on the left side of the display panel 100. The second dam DAM2 may be located on the outer side of the first dam DAM1. The first dam DAM1 may be located closer to the scan driving circuit SDC than the second dam DAM2 is, and the second dam DAM2 may be located closer to the edge EG of the display panel 100 than the first dam DAM1 is.

Although the first dam DAM1 and the second dam DAM2 are located on the first supply voltage line VSL in the example shown in FIG. 6, the embodiments of the present disclosure are not limited thereto. For example, one of the first dam DAM1 and the second dam DAM2 may not be located on the first supply voltage line VSL. Alternatively, none of the first dam DAM1 and the second dam DAM2 may be located on the first supply voltage line VSL. In this instance, the first dam DAM1 and the second dam DAM2 may be located on the outer side of the first supply voltage line VSL1.

In addition, although the display panel 100 includes the two dams DAM1 and DAM2 according to some embodiments as illustrated in FIG. 6, the embodiments of the present disclosure are not limited thereto. For example, a display panel 100 according to some embodiments may include three or more dams.

The second non-display area NDA2 may include a crack dam CRD and an edge area EGA.

The crack dam CRD may be a structure for preventing or reducing instances of cracks occurring during a process of cutting the substrate SUB in the process of fabricating the display device 10. The crack dam CRD may be the outermost structure located at the outermost position on the left side of the display panel 100. The crack dam CRD may be extended in the second direction (y-axis direction) in the non-display area NDA on the left side of the display panel 100.

The edge area EGA may be extended along the edge EG of the display panel 100. The edge area EGA may be an area in which processing marks occur during the process of cutting the substrate SUB.

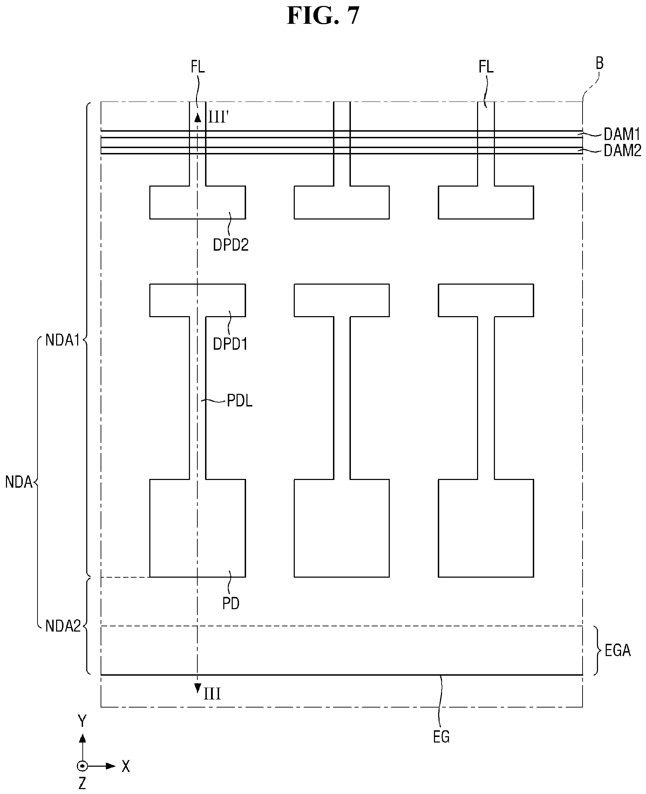

FIG. 7 is a layout diagram showing an example of the area B of FIG. 2 in more detail. FIG. 7 is a layout diagram showing a non-display area NDA located on the lower side of the display panel 100 according to some embodiments.

Referring to FIG. 7, the first non-display area NDA1 may include a plurality of display pads PD, a plurality of first driving pads DPD1, a plurality of second driving pads DPD2, a plurality of pad lines PDL, a plurality of fan-out lines, a first dam DAM1, and a second dam DAM2.

The plurality of display pads PD may be electrically connected to the circuit boards 300 through a conductive adhesive member such as an anisotropic conductive film and an anisotropic conductive adhesive. The plurality of display pads PD may be connected to the pad lines PDL, respectively. The pad lines PDL may connect the display pads PD with the first driving pads DPD1.

The plurality of first driving pads DPD1 and the plurality of second driving pads DPD2 may be electrically connected to the driving ICs 200 through a conductive adhesive member such as an anisotropic conductive film and an anisotropic conductive adhesive. The plurality of first driving pads DPD1 may be input pads for the driving ICs 200 to receive signals (e.g., digital video data, data timing control signal, etc.) of the circuit boards 300. The plurality of second driving pads DPD2 may be output pads for outputting signals (e.g., data voltages) of the driving ICs 200. The plurality of second driving pads DPD2 may be connected to the fan-out lines FL, respectively. The fan-out lines FL may connect the second driving pads DPD2 with the data lines of the display area DA.

The plurality of first driving pads DPD1 may be located closer to the display area DA in the second direction (y-axis direction) than the display pads PD connected thereto. That is to say, among the display pad PD and the first driving pad DPD1 connected to each other, the display pad PD may be located closer to the edge EG of the display panel 100 in the second direction (y-axis direction) than the first driving pad DPD1.

Each of the plurality of second driving pads DPD2 may be located closer to the display area DA in the second direction (y-axis direction) than one of the plurality of first driving pads DPD1. That is to say, the first driving pad DPD1 may be located closer to the edge EG of the display panel 100 in the second direction (y-axis direction) than one of the plurality of second driving pads DPD.

The first dam DAM1 and the second dam DAM2 may cross the fan-out lines FL. The first dam DAM1 and the second dam DAM2 may be extended in the first direction (x-axis direction) in the non-display area NDA on the lower side of the display panel 100. The second dam DAM2 may be located on the outer side of the first dam DAM1. The first dam DAM1 may be located closer to the display area DA2 than the second dam DAM2 is, and the second dam DAM2 may be located closer to the edge EG of the display panel 100 than the first dam DAM1 is.

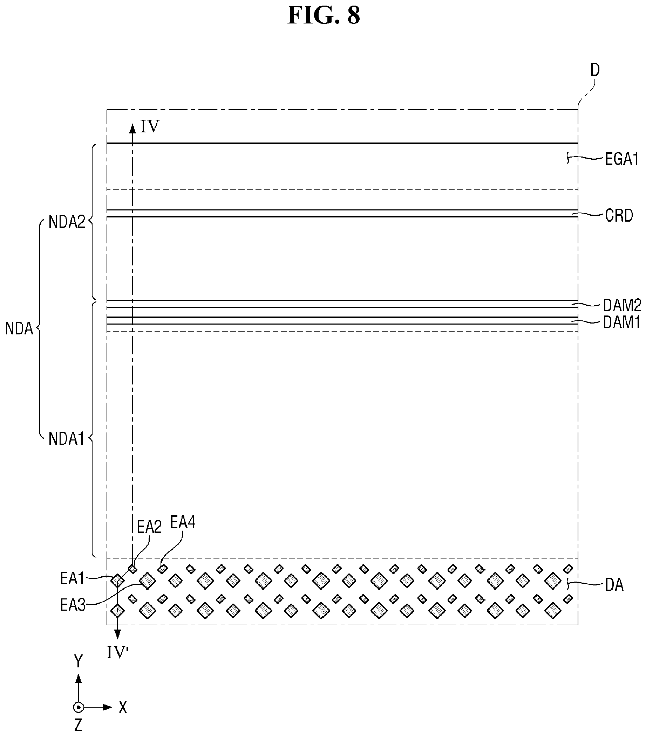

FIG. 8 is a layout diagram showing an example of the area D of FIG. 2 in more detail. FIG. 8 is a layout diagram showing a display area DA and a non-display area NDA located on the upper side of the display panel 100 according to some embodiments.

Referring to FIG. 8, the first non-display area NDA1 may include the first supply voltage line VSL, the first dam DAM1 and the second dam DAM2. The first non-display area NDA1 may not include the scan driving circuit SDC.

The first supply voltage line VSL may be extended in the first direction (x-axis direction) in the non-display area NDA on the upper side of the display panel 100. The first supply voltage line VSL may be electrically connected to the common electrode 173, and accordingly the common electrode 173 may receive a first supply voltage from the first supply voltage line VSL.

The first dam DAM1 and the second dam DAM2 may be extended in the first direction (x-axis direction) in the non-display area NDA on the upper side of the display panel 100. The second dam DAM2 may be located on the outer side of the first dam DAM1. The first dam DAM1 may be located closer to the display area DA than the second dam DAM2 is, and the second dam DAM2 may be located closer to the edge EG of the display panel 100 than the first dam DAM1 is.

Although the first dam DAM1 and the second dam DAM2 are located on the first supply voltage line VSL in the example shown in FIG. 8, the embodiments of the present disclosure are not limited thereto. For example, one of the first dam DAM1 and the second dam DAM2 may not be located on the first supply voltage line VSL. Alternatively, none of the first dam DAM1 and the second dam DAM2 may be located on the first supply voltage line VSL. In this instance, the first dam DAM1 and the second dam DAM2 may be located on the outer side of the first supply voltage line VSL1.

The second non-display area NDA2 may include a crack dam CRD and an edge area EGA.

The crack dam CRD may be the outermost structure located at the outermost position on the upper side of the display panel 100. The crack dam CRD may be extended in the first direction (x-axis direction) in the non-display area NDA on the upper side of the display panel 100.

The edge area EGA may be extended along the edge EG of the display panel 100. The edge area EGA may be an area in which processing marks occur during the process of cutting the substrate SUB.

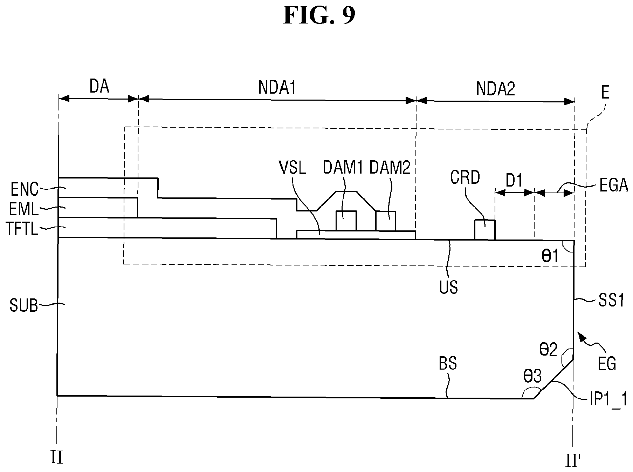

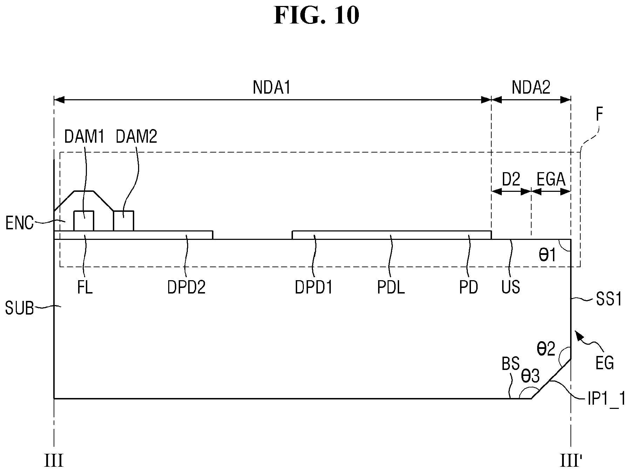

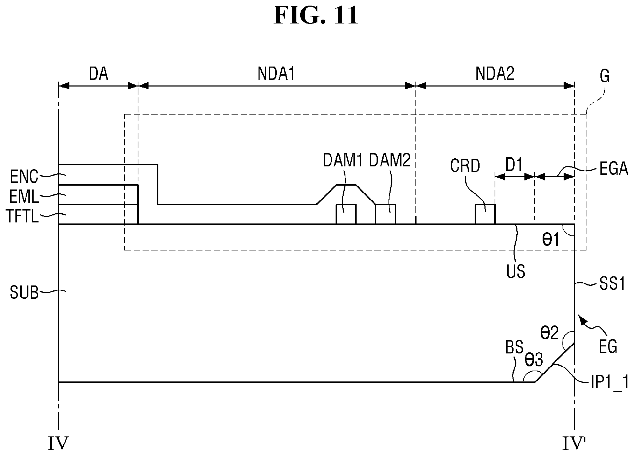

FIG. 9 is a cross-sectional view showing an example of a display panel taken along the line II - II' of FIG. 6. FIG. 10 is a cross-sectional view showing an example of the display panel taken along the line III - III' of FIG. 7. FIG. 11 is a cross-sectional view showing an example of the display panel, taken along the line IV - IV' of FIG. 8.

In the cross-sectional view of FIGS. 9 to 11, the edge EG of the display panel 100 is shown when the substrate SUB of the display panel 100 is cut by irradiating a laser and then spraying an etchant.

Referring to FIGS. 9 to 11, when the substrate SUB is cut by irradiating a laser and then spraying an etchant, processing marks may be formed the edge area EGA on the upper surface US of the substrate SUB by the etchant. The edge area EGA may be within approximately 30 µm.

The edge area EGA may include a first inclined surface IP1_1 formed by irradiating a laser and then spraying an etchant. The angle θ1 between the side surface SS1 and the upper surface US may be approximately 90 degrees. In other words, the side surface SS1 may be substantially perpendicular to the upper surface US. An angle θ2 between the side surface SS1 and the first inclined surface IP1_1 and an angle θ3 between the first inclined surface IP1_1 and the bottom surface BS may be obtuse angles. The processing marks formed on the upper surface UP of the substrate SUB may overlap the first inclined surface IP1_1 in the third direction (z-axis direction).

The crack dam CRD may be a structure for preventing or reducing instances of cracks occurring during a process of cutting the substrate SUB in the process of fabricating the display device 10. The crack dam CRD may be the outermost structure located at the outermost position on the left side of the display panel 100. The distance D1 between the crack dam CRD and the edge area EGA may be equal to or less than approximately 70 µm. The crack dam CRD may be located at the upper Surface US.

The minimum distance from the crack dam CRD to the edge EG of the display panel 100 may be equal to the sum of the width of the edge area EGA and the minimum distance D1 from the crack dam CRD to the edge area EGA. When the substrate SUB is cut by irradiating a laser and then spraying an etchant, the minimum distance between the crack dam CRD and the edge EG of the display panel 100 may vary depending on the unilateral tolerance of the laser. For example, when the unilateral tolerance of the laser is 50 µm, the distance D1 between the crack dam CRD and the edge area EGA may be at least 50 µm or less, or at most 150 µm or less.

The minimum distance from the display pad PD to the edge of the substrate SUB may be equal to the sum of the width of the edge area EGA and the minimum distance D2 from the display pad PD to the edge area EGA. When the substrate SUB is cut by irradiating a laser and then spraying an etchant, the minimum distance between the display pad PD and the edge of the substrate SUB may vary depending on the unilateral tolerance of the laser. For example, when the unilateral tolerance of the laser is 50 µm, the distance D2 between the crack dam CRD and the edge area EGA may be at least 50 µm or less, or at most 150 µm or less.

In addition, when the substrate SUB of the display panel 100 is cut by irradiating a laser and then spraying an etchant during the process of fabricating the display panel 100, the side surface SS of the display panel 100 and the first inclined surface IP1 may be etched by the etchant. In this instance, the roughness of the side surface SS of the display panel 100 and the first inclined surface IP1 may be approximately 50 µm or less. The roughness of the side surface SS and the first inclined surface IP1 of the display panel 100 when the substrate SUB of the display panel 100 is cut by irradiating the laser and then spraying the etchant may be smaller than the roughness of the side surface SS, the first inclined surface IP1 and the second inclined surface IP2 of the display panel 100 when the substrate SUB is cut with a cutting member and then a polishing process is performed.

When the substrate SUB of the display panel 100 is cut by irradiating the laser and then spraying the etchant, the minimum distance from the crack dam CRD to the edge EG of the display panel 100 can be reduced. Therefore, when the substrate SUB of the display panel 100 is cut by irradiating the laser and then spraying the etchant, the width of the second non-display area NDA2 can be greatly reduced. In other words, the width of the non-display area NDA can be reduced.

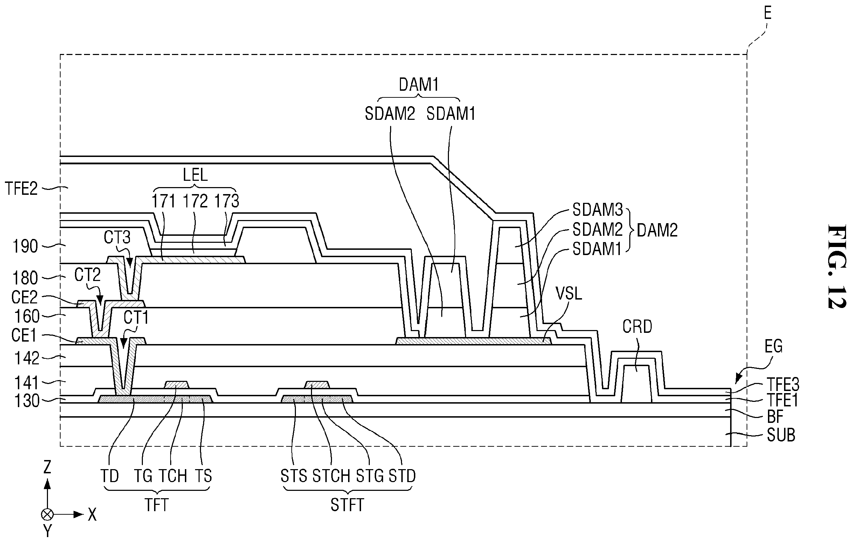

FIG. 12 is an enlarged, cross-sectional view showing in more detail an example of the area E of FIG. 9.

Referring to FIG. 12, the crack dam CRD may include the same material as the first organic film 160. The crack dam CRD may be located on the buffer film BF. The crack dam CRD may be formed of an organic layer such as an acryl resin, an epoxy resin, a phenolic resin, a polyamide resin and a polyimide resin.

Although the crack dam CRD includes one organic film layer in the example shown in FIG. 12, the embodiments of the present disclosure are not limited thereto. For example, the crack dam CRD may further include another organic film layer including the same material as the second organic film 180. Alternatively, the crack dam CRD may further include another organic film layer including the same material as the bank 190. Alternatively, the crack dam CRD may further include yet another organic film layer including the same material as a spacer 191 (see FIG. 5).

The first supply voltage line VSL may include the same material as the first data metal layer including the first connection electrode CE1 and the data lines, and may be located on the same layer. The first supply voltage line VSL may be located on the second interlayer dielectric film 142. The first supply voltage line VSL may be made up of a single layer or multiple layers of one of molybdenum (Mo), aluminum (Al), chromium (Cr), gold (Au), titanium (Ti), nickel (Ni), neodymium (Nd) and copper (Cu) or an alloy thereof.

The first dam DAM1 and the second dam DAM2 may be located on the first supply voltage line VSL. The first dam DAM1 may include a first sub-dam SDAM1 and a second sub-dam SDAM2, and the second dam DAM2 may include a first sub-dam SDAM1, a second sub-dam SDAM2 and a third sub-dam SDAM3. The first sub-dam SDAM1 may include the same material as the first organic film 160 and may be located on the same layer. The second sub-dam SDAM1 may include the same material as the second organic film 180 and may be located on the same layer. The third sub-dam SDAM3 may include the same material as the bank 190 and may be located on the same layer.

The height of the first dam DAM1 may be lower than the height of the second dam DAM2, but the embodiments of the present disclosure are not limited thereto. The height of the first dam DAM1 may be substantially equal to or higher than the height of the second dam DAM2 .

The common electrode 173 may be connected to a portion of the first supply voltage line VSL that is exposed without being covered by the first organic film 160, the second organic film 180 and the first dam DAM1. Accordingly, the common electrode 173 may receive the first supply voltage from the first supply voltage line VSL.

The first inorganic encapsulation film TFE1 may cover the first dam DAM1, the second dam DAM2 and the crack dam CRD in the non-display area NDA on the left side of the display panel 100. The first inorganic encapsulation film TFE1 may be extended to the vicinity of the edge EG of the display panel 100 in the non-display area NDA on the lower side of the display panel 100. The side surface of the first inorganic encapsulation film TFE1 may be aligned with the side surface of the substrate SUB.

The organic encapsulation film TFE2 may be arranged to cover the top surface of the first dam DAM1 but not the top surface of the second dam DAM2. It should be understood, however, that the present disclosure is not limited thereto. The organic encapsulation film TFE2 may cover neither the top surface of the first dam DAM1 nor the top surface of the second dam DAM2. It may be possible to prevent or reduce instances of the organic encapsulation film TFE2 overflowing to the edge EG of the display panel 100 by virtue of the first dam DAM1 and the second dam DAM2.

The second inorganic encapsulation film TFE3 may cover the first dam DAM1, the second dam DAM2 and the crack dam CRD in the non-display area NDA on the lower side of the display panel 100. The second inorganic encapsulation film TFE3 may be extended to the vicinity of the edge EG of the display panel 100 in the non-display area NDA on the lower side of the display panel 100. The side surface of the second inorganic encapsulation film TFE3 may be aligned with the side surface of the substrate SUB.

There may be formed an inorganic encapsulation area from the second dam DAM2 to the edge EG of the display panel 100, in which the first inorganic encapsulation film TFE1 and the second inorganic encapsulation film TFE3 are in contact with each other. The inorganic encapsulation area may surround the second dam DAM2.

Incidentally, in FIG. 12, a scan thin-film transistor STFT of the scan driving circuit SDC is illustrated. Since the scan thin-film transistor STFT is substantially identical to the thin-film transistor TFT described above with reference to FIG. 5; and, therefore, the scan thin-film transistor STFT will not be described.

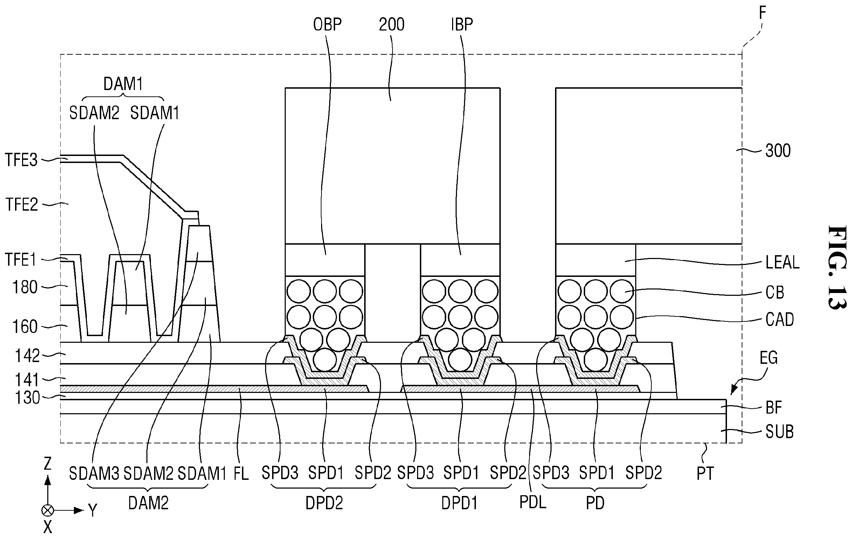

FIG. 13 is an enlarged, cross-sectional view showing in more detail an example of the area F of FIG. 10.

Referring to FIG. 13, each of the display pad PD, the first driving pad DPD1 and the second driving pad DPD2 may include a first subsidiary pad SPD1, a second subsidiary pad SPD2, and a third subsidiary pad SPD3.

The first subsidiary pad SPD1 may include the same material as the first gate metal layer including the gate electrode TG, the first capacitor electrode CAE1 of the capacitor Cst and the scan lines, and may be located on the same layer. The first subsidiary pad SPD1 may be located on the gate insulator 130. The first subsidiary pad SD1 may be made up of a single layer or multiple layers of one of molybdenum (Mo), aluminum (Al), chromium (Cr), gold (Au), titanium (Ti), nickel (Ni), neodymium (Nd) and copper (Cu) or an alloy thereof.

The second subsidiary pad SPD2 may include the same material as the second gate metal layer including the second capacitor electrode CAE2 and may be located on the same layer. The second subsidiary pad SPD2 may be located on the first interlayer dielectric film 141. The second subsidiary pad SD2 may be made up of a single layer or multiple layers of one of molybdenum (Mo), aluminum (Al), chromium (Cr), gold (Au), titanium (Ti), nickel (Ni), neodymium (Nd) and copper (Cu) or an alloy thereof.

The third subsidiary pad SPD3 may include the same material as the first data metal layer including the first connection electrode CE1 and the data lines, and may be located on the same layer. The third subsidiary pad SPD3 may be located on the second interlayer dielectric film 142. The third subsidiary pad SD3 may be made up of a single layer or multiple layers of one of molybdenum (Mo), aluminum (Al), chromium (Cr), gold (Au), titanium (Ti), nickel (Ni), neodymium (Nd) and copper (Cu) or an alloy thereof.

The third subsidiary pad SPD3 of the display pad PD may be electrically connected to the circuit board 300 through a conductive adhesive member such as an anisotropic conductive film and an anisotropic conductive adhesive. The third subsidiary pad SPD3 of the first driving pad DPD1 may be electrically connected to an input bump of the driving IC 200 through a conductive adhesive member such as an anisotropic conductive film and an anisotropic conductive adhesive. The third subsidiary pad SPD3 of the second driving pad DPD2 may be electrically connected to an output bump of the driving IC 200 through a conductive adhesive member such as an anisotropic conductive film and an anisotropic conductive adhesive. In FIG. 13, the driving ICs 200 and the circuit boards 300 are omitted for convenience of illustration.

The first inorganic encapsulation film TFE1 and the second inorganic encapsulation film TFE2 may be arranged to cover the first dam DAM1 and partially cover the second dam DAM2. For example, the first inorganic encapsulation film TFE1 and the second inorganic encapsulation film TFE2 may be arranged such that it does not cover a portion of the upper surface of the second dam DAM2. Alternatively, the first inorganic encapsulation film TFE1 and the second inorganic encapsulation film TFE2 may cover them, but in this case, they may not cover the third subsidiary pad SPD3 of the second driving pad DPD2. That is to say, the first inorganic encapsulation film TFE1 and the second inorganic encapsulation film TFE2 may not be extended to the display pad PD, the first driving pad DPD1 and the second driving pad DPD2 located adjacent to the edge EG of the display panel 100.

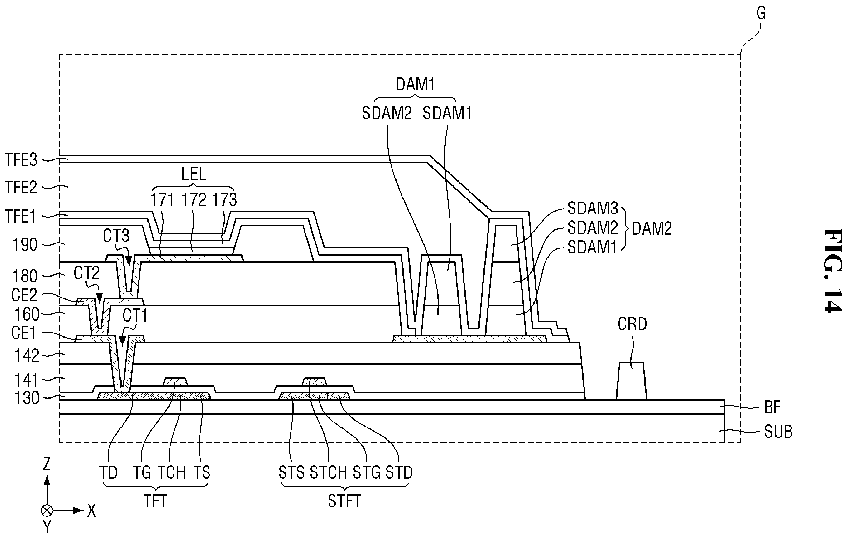

FIG. 14 is an enlarged, cross-sectional view showing in more detail an example of the area G of FIG. 11.

Referring to FIG. 14, the first inorganic encapsulation film TFE1 and the second inorganic encapsulation film TFE3 may be arranged such that it does not cover the crack dam CRD in the non-display area NDA on the upper side of the display panel 100. That is to say, in the non-display area NDA on the upper side of the display panel 100, the first inorganic encapsulation film TFE1 and the second inorganic encapsulation film TFE3 may not be extended to the edge EG of the display panel 100.

In addition, the first inorganic encapsulation film TFE1 and the second inorganic encapsulation film TFE3 may be arranged such that they do not cover the crack dam CRD in the non-display area NDA on the left and right sides of the display panel 100, in addition to the non-display area NDA on the upper side of the display panel 100. That is to say, the first inorganic encapsulation film TFE1 and the second inorganic encapsulation film TFE3 may not be extended to the edge EG of the display panel 100 in the non-display area NDA on the left and right sides of the display panel 100, in addition to the non-display area NDA on the upper side of the display panel 100.

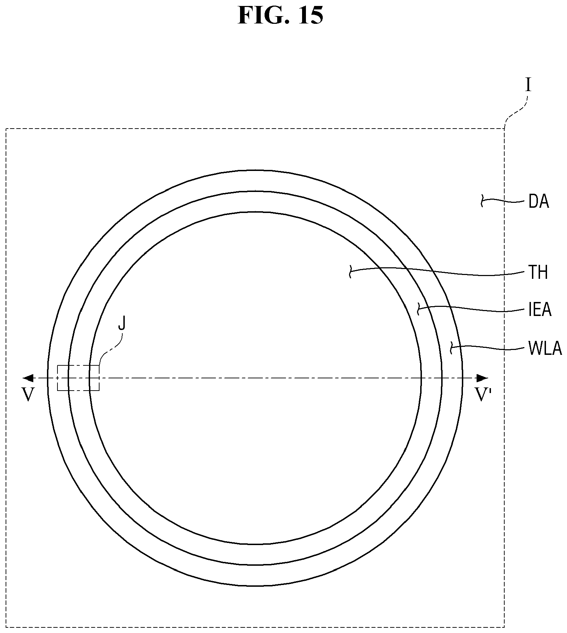

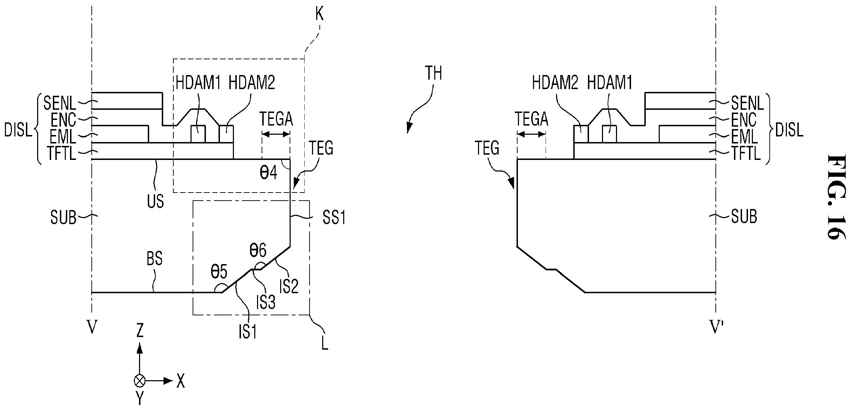

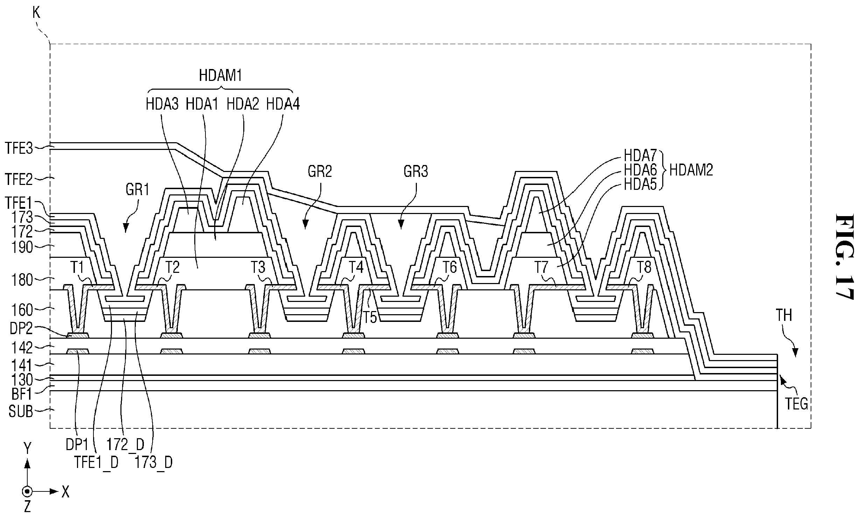

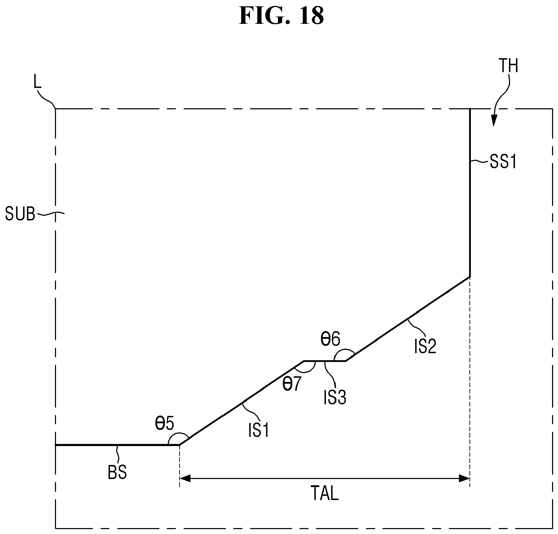

FIG. 15 is a layout diagram showing an example of a through hole, an inorganic encapsulation area, a wiring area and a display area of a display panel according to some embodiments. FIG. 16 is a cross-sectional view showing an example of the display panel taken along the line V - V' of FIG. 15. FIG. 17 is an enlarged, cross-sectional view showing in more detail examples of the area K of FIG. 15. FIGS. 18 to 22 are enlarged cross-sectional views showing a variety of examples of the area L of FIG. 15.

Referring to FIGS. 15 to 17, the display panel 100 according to some embodiments of the present disclosure includes the inorganic encapsulation area IEA surrounding the through hole TH and a wiring area WLA surrounding the inorganic encapsulation area IEA.

In the inorganic encapsulation area IEA, the first inorganic encapsulation film TFE1 and the second inorganic encapsulation film TFE3 of the encapsulation layer ENC come in contact with each other to prevent or reduce instances of oxygen or moisture permeating into the light emitting element layer EML of the display layer DISL due to the through hole TH.

The inorganic encapsulation area IEA may include at least one dam, at least one tip, and at least one groove. For example, the inorganic encapsulation area IEA may include a first dam HDAM1, a second dam HDAM2, first to eighth tips T1 to T8, and first to third grooves as shown in FIG. 8, which will be described later.

The first tip T1 and the second tip T2 may be located closer to the wiring area WLA than the first dam HDAM1 is. The first tip T1 may be located closer to the wiring area WLA than the second tip T2 is. The second tip T2 may be located between the first tip T1 and the first dam HDAM1.

The third tip T3, the fourth tip T4, the fifth tip T5 and the sixth tip T6 may be located between the first dam HDAM1 and the second dam HDAM2. At least a portion of the third tip T3 may overlap with the first dam HDAM1 in the third direction (z-axis direction).

The seventh tip T7 and the eighth tip T8 may be located closer to the through hole TH than the second dam HDAM2 is. At least a portion of the seventh tip T7 may overlap with the second dam HDAM2 in the third direction (z-axis direction). The distance between the eighth tip T8 and the through hole TH may be approximately 50 µm.

A first groove GR1 may be located between the first tip T1 and the second tip T2. A second groove GR2 may be located between the third tip T3 and the fourth tip T4. A third groove GR3 may be located between the fifth tip T5 and the sixth tip T6.

In the wiring area WLA, lines are extended around the through hole TH. Some of such lines may be connected to the data lines, while some others of them may be connected to a second supply voltage line from which a second supply voltage higher than the first supply voltage is applied. Still some others of them may be connected to the scan lines. The wiring area WLA may be surrounded by the display area DA.

In the cross-sectional view of FIG. 16, an edge TEG of the through hole TH is shown when the substrate SUB of the display panel 100 is cut by irradiating a laser and then spraying an etchant.

Referring to FIG. 16, when the substrate SUB is cut by irradiating a laser and then spraying an etchant, processing marks may be formed the through-hole edge area TEGA on the upper surface US of the substrate SUB by the etchant. The through-hole edge area TEGA may be within approximately 30 µm.

The through-hole edge area TEGA may include a first surface IS1, a second surface IS2 and a third surface IS3 between the first surface IS1 and the second surface IS2, which are formed by spraying an etchant after irradiating a laser. The first surface IS1 and the second surface IS2 may be inclined surfaces. The first surface IS1 and the second surface IS2 may be spaced apart from each other with the third surface IS3 therebetween. In other words, the substrate SUB may include a plurality of inclined surfaces, in particular two inclined surfaces IS1, IS2, spaced apart from each other.

An angle θ4 between the side surface SS1 and the upper surface US may be approximately 90 degrees. The angle θ4 may be the same angle θ1 as shown in figs. 9 to 11. In other words, the side surface SS1 may be substantially perpendicular to the upper surface US. An angle θ5 between the bottom surface BS and the first surface IS1 and an angle θ6 between the third surface IS3 and the second surface IS2 may be obtuse angles. In other words, an angle θ5 between the bottom surface BS and the first surface IS1 and an angle θ6 between the third surface IS3 and the second surface IS2 may be greater than 90 degrees. The processing marks formed on the upper surface UP of the substrate SUB may overlap the second surface US2 in the third direction (z-axis direction). It should be understood, however, that the present disclosure is not limited thereto. the processing marks formed on the upper surface UP of the substrate SUB may overlap the first surface IS1, the second surface IS2 and the third surface IS3.

The angle θ5 between the bottom surface BS and the first surface IS1 and the angle Θ6 between the third surface IS3 and the second surface IS2 may vary depending on the depth of the laser irradiation area formed by the laser when the substrate SUB of the display panel 100 is cut by irradiating the laser and then spraying the etchant. The depth of the laser irradiation area formed by the laser to cut along the edge EG of the display panel 100 may be different from the depth of the laser irradiation area formed by the laser to cut along the edge TEG of the through hole TH. The first surface IS1, the second surface IS2 and the third surface IS3 will be described in more detail with reference to FIGS. 18 to 22 to be described later.

Referring to FIG. 17, a first dummy pattern DP1 may include the same material as the second gate metal layer including the second capacitor electrode CAE2 of the capacitor Cst and may be located on the same layer. For example, the first dummy pattern DP1 may be located on the first interlayer dielectric film 141. The first dummy pattern DP1 may be made up of a single layer or multiple layers of one of molybdenum (Mo), aluminum (Al), chromium (Cr), gold (Au), titanium (Ti), nickel (Ni), neodymium (Nd) and copper (Cu) or an alloy thereof.

A second dummy pattern DP2 may include the same material as the first data metal layer including the first connection electrode CE1 and the data lines, and may be located on the same layer. For example, the second dummy pattern DP2 may be located on the second interlayer dielectric film 142. The second dummy pattern DP2 may be made up of a single layer or multiple layers of one of molybdenum (Mo), aluminum (Al), chromium (Cr), gold (Au), titanium (Ti), nickel (Ni), neodymium (Nd) and copper (Cu) or an alloy thereof.

The second dummy pattern DP2 may overlap with the first dummy pattern DP1 in the third direction (z-axis direction).

The first to eighth tips T1 to T8 may include the same material as the second data metal layer including the second connection electrode CE2 and may be located on the same layer. For example, the first to eighth tips T1 to T8 may be located on the first organic film 160. The first to eighth tips T1 to T8 may be made up of a single layer or multiple layers of one of molybdenum (Mo), aluminum (Al), chromium (Cr), gold (Au), titanium (Ti), nickel (Ni), neodymium (Nd) and copper (Cu) or an alloy thereof.

Each of the first to eighth tips T1 to T8 may be connected to the second dummy pattern DP2 through a contact hole penetrating the first organic film 160. Each of the first to eighth tips T1 to T8 may include an eaves structure that has an upper surface and a lower surface (or bottom surface) exposed without being covered by the first organic film 160, the second organic film 180, the first dam HDAM1 and the second dam HDAM2. The fourth tip T4 and the fifth tip T5 may be formed integrally. Each of the first to eighth tips T1 to T8 may be a protrusion pattern or a trench pattern for forming a groove (or trench). The eighth tip T8 may be the outermost structure adjacent to the edge TEG of the through hole TH. Although the eighth tip T8 is depicted as the outermost structure adjacent to the edge TEG of the through hole TH in FIG. 17, the embodiments of the present disclosure are not limited thereto. For example, if the seventh tip T7 and the eighth tip T8 are eliminated, the second dam HDAM2 may be the outermost structure adjacent to the edge TEG of the through hole TH that can prevent or reduce instances of the organic encapsulation film TFE2 of the encapsulation layer ENC overflowing. Alternatively, if the seventh tip T7 and the eighth tip T8 are eliminated, a groove that separates the emissive layer 172 from the common electrode 173 may be the outermost structure adjacent to the edge TEG of the through hole TH.

The distance from the eighth tip T8 to the edge TEG of the through hole TH may be approximately 300 µm. The through-hole edge area TEGA may be located between the eighth tip T8 and the edge TEG of the through hole TH.

The first groove GR1 may be formed between the first tip T1 and the second tip T2, the second groove GR2 may be formed between the third tip T3 and the fourth tip T4, and the third groove GR3 may be formed between the fifth tip T5 and the sixth tip T6. The first groove GR1 may have eaves structures formed by the first tip T1 and the second tip T2, the second groove GR2 may have eaves structures formed by the third tip T3 and the fourth tip T4, and the third groove GR3 may have eaves structures formed by the fifth tip T5 and the sixth tip T6.

Since the emissive layer 172 is deposited by evaporation and the common electrode 173 is deposited by sputtering, the step coverage is low and thus it may be broken in each of the first to third grooves GR1, GR2 and GR3. On the other hand, since the first inorganic encapsulation film TFE1 and the third inorganic encapsulation film TFE3 are deposited by chemical vapor deposition, atomic layer deposition, etc., they have a high step coverage and thus may not be disconnected in each of the first to third grooves GR1, GR2, and GR3. Herein, the step coverage refers to a ratio of a thin film applied on an inclined portion to the thin film applied on a flat portion. In each of the first to third grooves GR1, GR2 and GR3, there may be a residue 172_D disconnected from the emissive layer 172, and a residue 173_D disconnected from the common electrode 173.

The first dam HDAM1 may include first to fourth sub-dams HDA1, HDA2, HDA3 and HDA4. The first sub-dam HDA1 may be located on the first organic film 160 and may include the same material as the second organic film 180. The first sub-dam HDA1 may be located on the second tip T2 and the third tip T3. The second sub-dam HDA2 may be located on the first sub-dam HDA1 and may include the same material as the bank 190. The third sub-dam HDA3 and the fourth sub-dam HDA4 may be located on the second sub-dam HDA2 and may include the same material as the spacer 191. It should be understood, however, that the present disclosure is not limited thereto. The fourth sub-dam HDA4 may be located closer to the through hole TH than the third sub-dam HDA3 is. The thickness of the fourth sub-dam HDA4 may be greater than the thickness of the third sub-dam HDA3.

The second dam HDAM2 may include fifth to seventh sub-dams HDA5, HDA6 and HDA7. The fifth sub-dam HDA5 may be located on the first organic film 160 and may include the same material as the second organic film 180. The fifth sub-dam HDA5 may be located on the seventh tip T7. The sixth sub-dam HDA6 may be located on the fifth sub-dam HDA5 and may include the same material as the bank 190. The seventh sub-dam HDA7 may be located on the sixth sub-dam HDA6 and may include the same material as the spacer 191. It should be understood, however, that the present disclosure is not limited thereto.

It may be possible to prevent or reduce the organic encapsulation film TFE2 overflowing into the through hole TH by virtue of the first dam HDAM1 and the second dam HDAM2.

The residue 172_D, the residue 173_D, the first inorganic encapsulation film TFE1 and the second inorganic encapsulation film TFE3 may be extended to the edge TEG of the through hole TH. The end of the residue 172_D, the end of the residue 173_D, the end of the first inorganic encapsulation film TFE1 and the end of the second inorganic encapsulation film TFE3 may be aligned with the edge TEG of the through hole TH.

As shown in FIG. 17, the emissive layer 172 and the common electrode 173 are disconnected in each of the first to third grooves GR1, GR2 and GR3 formed by the first to eighth tips T1 to T8, it may be possible to prevent or reduce instances of oxygen, moisture, etc. permeating through the emissive layer 172 and the common electrode 173 exposed via the through hole TH.

According to some embodiments as illustrated in FIG. 18, there may be a stepped edge between the side surface SS1 and the bottom surface BS in the through hole TH of the substrate SUB. For example, the substrate SUB may include a first surface IS1, a second surface IS2 and a third surface IS3 between the side surface SS1 and the bottom surface BS. The first surface IS1 may meet the bottom surface BS and may be extended from the bottom surface BS at a predetermined angle. The second surface IS2 may meet the side surface SS1 and may be extended from the side surface SS1 at a predetermined angle. The third surface IS3 may be located between the first surface IS1 and the second surface IS2, and one end may meet the first surface IS1 and the other end may meet the second surface IS2.

The angle θ5 between the bottom surface BS and the first surface IS1 and the angle Θ6 between the second surface IS2 and the third surface IS3 may be obtuse angles. The angle θ7 between the first surface IS1 and the third surface IS3 may be equal to the angle θ5 between the bottom surface BS and the first surface IS1. The angle θ7 between the first surface IS1 and the third surface IS3 may be an external angle of the substrate SUB.

According to some embodiments of the present disclosure, the first surface IS1, the second surface IS2 and the third surface IS3 between the side surface SS1 and the bottom surface BS may be formed on the substrate SUB. There may be a stepped edge, i.e., two steps between the bottom surface BS and the third surface IS3 and between the third surface IS3 and the side surface SS1. Such steps may be formed by laser irradiation areas formed by laser irradiation twice or more, which will be described later. A more detailed description thereon will be given below.

The first surface IS1 and the second surface IS2 may be inclined surfaces. The length of the first surface IS1 in an inclined direction may be equal to the length of the second surface IS2 in the inclined direction. The lengths of the first surface IS1 and the second surface IS2 may be adjusted depending on the spacing or depth of laser irradiation areas, which will be described later. The third surface IS3 may be extended in parallel to the bottom surface BS or the upper surface US. The length of the third surface IS3 may be smaller than the length of each of the first surface IS1 and the second surface IS2 between the first surface IS1 and the second surface IS2. It is, however, to be understood that the present disclosure is not limited thereto.

In addition, the length TAL formed by the first surface IS1, the second surface IS2 and the third surface IS3 between the side surface SS1 and the bottom surface BS may be approximately 100 µm to 500 µm. For example, the length TAL between the end of the bottom surface BS and the side surface SS1 may be approximately 100 µm to 500 µm when viewed from the top. It is, however, to be understood that the present disclosure is not limited thereto. As the length TAL formed by the first surface IS1, the second surface IS2 and the third surface IS3 increases, the substrate SUB can be easily separated from the mother substrate at the through hole TH. If the substrate SUB is not easily separated from the mother substrate, it may be contemplated to separate the substrate SUB by physically striking. However, there may arise a chipping issue that the substrate SUB is damaged at the edge of the through hole TH. According to some embodiments, by forming the substrate SUB including the first surface IS1, the second surface IS2 and the third surface IS3, it may be possible to easily separate the substrate SUB at the through hole TH.

According to some embodiments of the present disclosure, the substrate SUB has a step between the bottom surface BS and the third surface IS3 and a step between the third surface IS3 and the side surface SS1, thereby reducing the angle of the edge of the side surface of the substrate SUB. In this manner, it may be possible to prevent or reduce instances of the substrate SUB being easily damaged by an external impact due to a sharp edge on the side surface of the substrate SUB.

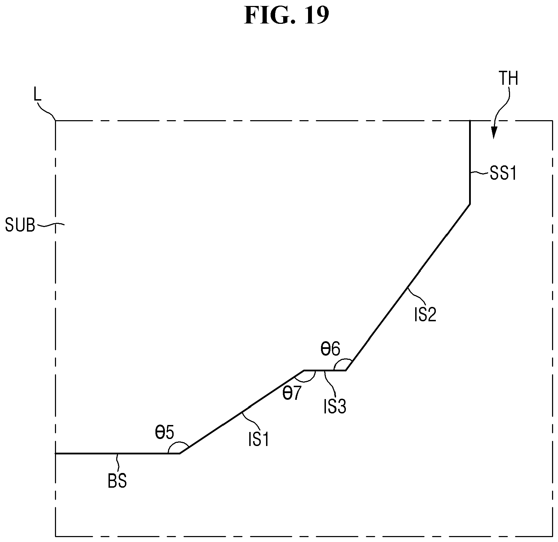

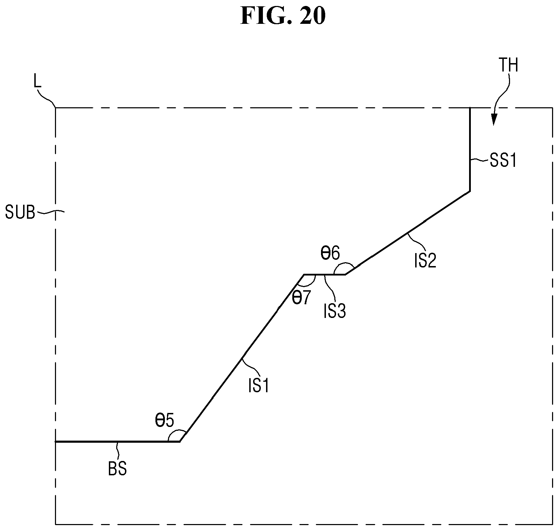

Referring to FIGS. 19 and 20, in a substrate according to some embodiments, the length of the first surface IS1 in the inclined direction may be different from the length of the second surface IS2 in the inclined direction, and the angle θ5 between the bottom surface BS and the first surface IS1 may be different from the angle θ6 between the second surface IS2 and the third surface IS3.

As shown in FIG. 19, the length of the second surface IS2 in the inclined direction may be greater than the length of the first surface IS1 in the inclined direction. The length of the second surface IS2 in the inclined direction may be formed by increasing the depth of the second laser irradiation area formed by irradiating a second laser to be described later. In addition, the length of the second surface IS2 in the inclined direction may be formed by increasing the spacing between a third laser irradiation area formed by irradiating a second laser to be described later and the second laser irradiation area.

In addition, the angle θ5 between the bottom surface BS and the first surface IS1 may be greater than the angle Θ6 between the second surface IS2 and the third surface IS3. Such structural features may be formed by adjusting the spacing or depth of the laser irradiation areas as described above.

In the example shown in FIG. 19, the length of the second surface IS2 in the inclined direction is greater than the length of the first surface IS1 in the inclined direction, and the angle θ5 between the bottom surface BS and the first surface IS1 is greater than the angle Θ6 between the second surface IS2 and the third surface IS3. It should be understood, however, that the present disclosure is not limited thereto. The length of the second surface IS2 in the inclined direction may be greater than the length of the first surface IS1 in the inclined direction, and the angle θ5 between the bottom surface BS and the first surface IS1 may be equal to the angle Θ6 between the second surface IS2 and the third surface IS3. In addition, the angle θ5 between the bottom surface BS and the first surface IS1 may be greater than the angle Θ6 between the second surface IS2 and the third surface IS3, and the length of the second surface IS2 in the inclined direction may be equal to the length of the first surface IS1 in the inclined direction.

As shown in FIG. 20, the length of the first surface IS1 in the inclined direction may be greater than the length of the second surface IS2 in the inclined direction. The length of the first surface IS1 in the inclined direction may be formed by increasing the depth of the third laser irradiation area formed by irradiating a third laser to be described later. In addition, the angle Θ6 between the second surface IS2 and the third surface IS3 may be greater than the angle θ5 between the bottom surface BS and the first surface IS1. Such structural features may be formed by adjusting the depth of the laser irradiation areas as described above.

In the example shown in FIG. 20, the length of the first surface IS1 in the inclined direction is greater than the length of the second surface IS2 in the inclined direction, and the angle θ6 between the second surface IS2 and the third surface IS3 is greater than the angle θ5 between the bottom surface BS and the first surface IS1. It should be understood, however, that the present disclosure is not limited thereto. The length of the first surface IS1 in the inclined direction may be greater than the length of the second surface IS2 in the inclined direction, and the angle θ5 between the bottom surface BS and the first surface IS1 may be equal to the angle θ6 between the second surface IS2 and the third surface IS3. In addition, the angle θ6 between the second surface IS2 and the third surface IS3 may be greater than the angle θ5 between the bottom surface BS and the first surface IS1, and the length of the first surface IS1 in the inclined direction may be equal to the length of the second surface IS2 in the inclined direction.

Incidentally, the third surface IS3 of the substrate SUB may not be parallel to the bottom surface BS or the upper surface US.

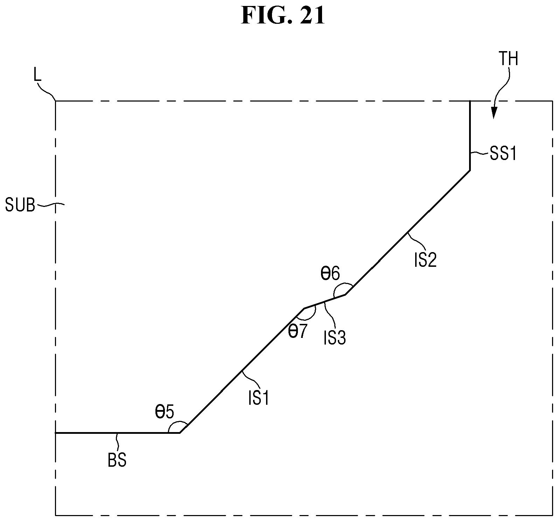

Referring to FIG. 21, according to some embodiments, the third surface IS3 may be an inclined surface. For example, the angle θ7 between the third surface IS3 and the first surface IS1 may be different from the angle θ5 between the bottom surface BS and the first surface IS1. In other words, the third surface IS3 and the bottom surface BS may not be in parallel. The angle θ7 between the third surface IS3 and the first surface IS1 may be greater than the angle θ5 between the bottom surface BS and the first surface IS1. In addition, the angle θ7 between the third surface IS3 and the first surface IS1 may be greater than the angle θ6 between the side surface SS1 and the second surface IS2.

In addition, the first surface IS1 and the second surface IS2 of the substrate SUB may be curved surfaces, unlike the flat surfaces according to the above embodiments of FIGS. 18 to 21.

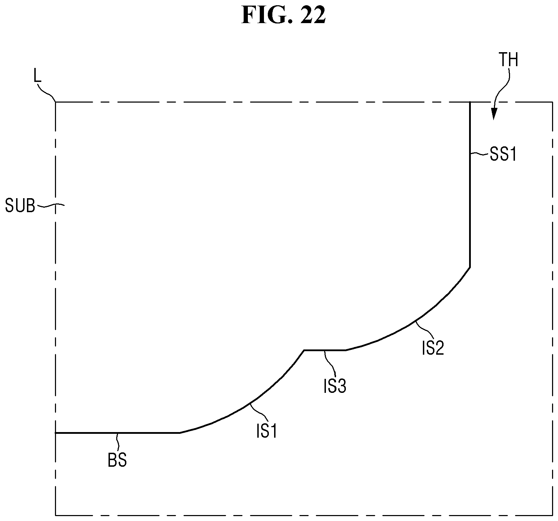

Referring to FIG. 22, according to some embodiments, the first surface IS1 and the second surface IS2 of the substrate SUB may be curved surfaces. For example, the first surface IS1 may be a convex surface between the bottom surface BS and the third surface IS3. The second surface IS2 may be a convex surface between the side surface SS1 and the third surface IS3. It should be understood, however, that the present disclosure is not limited thereto. One of the first surface IS1 and the second surface IS2 may be a curved surface while the other one may be a straight surface.

Although the first surface IS1 and the second surface IS2 are convex surfaces in FIG. 22, the present disclosure is not limited thereto. At least one of the first surface IS1 or the second surface IS2 may be a concave surface. In addition, although the third surface IS3 is a straight surface, the present disclosure is not limited thereto. The third surface IS3 may not be parallel to the bottom surface BS and may be a convex surface.

Hereinafter, a method of fabricating the above-described display device will be described with reference to other drawings.

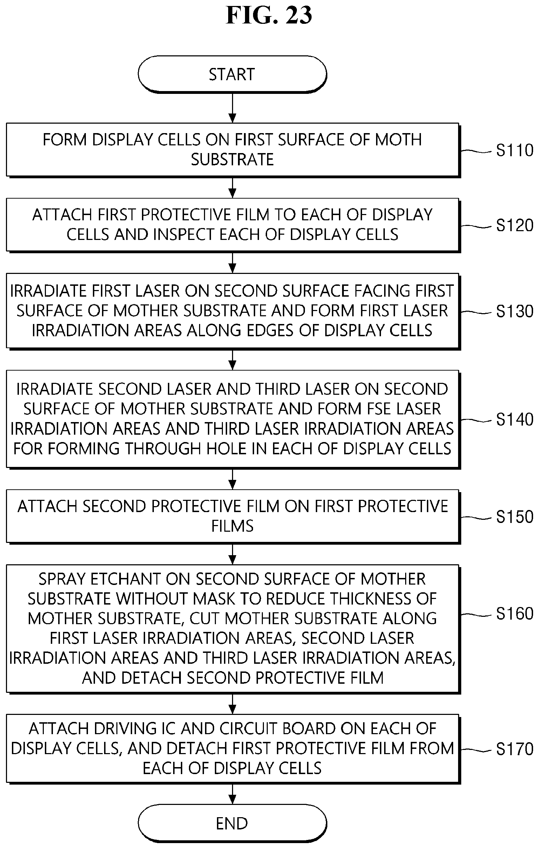

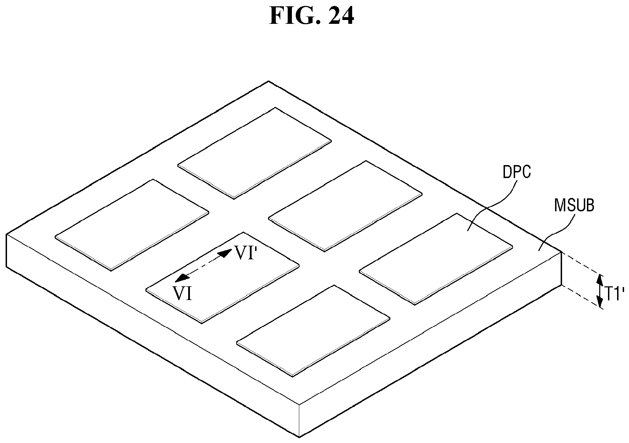

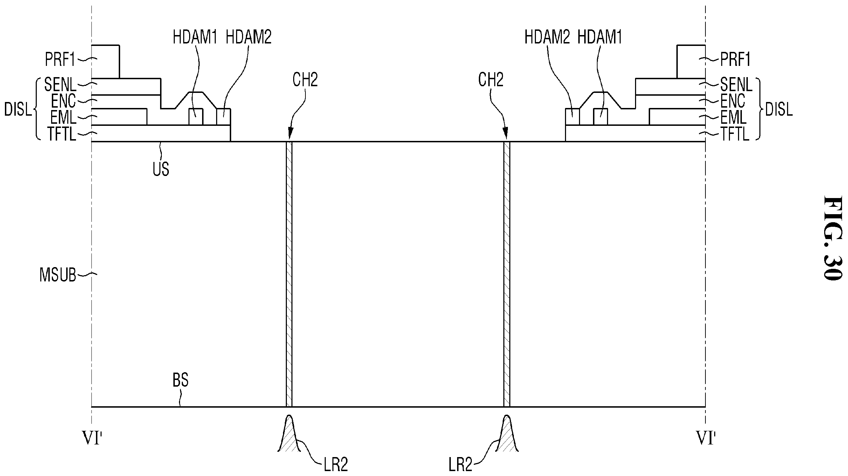

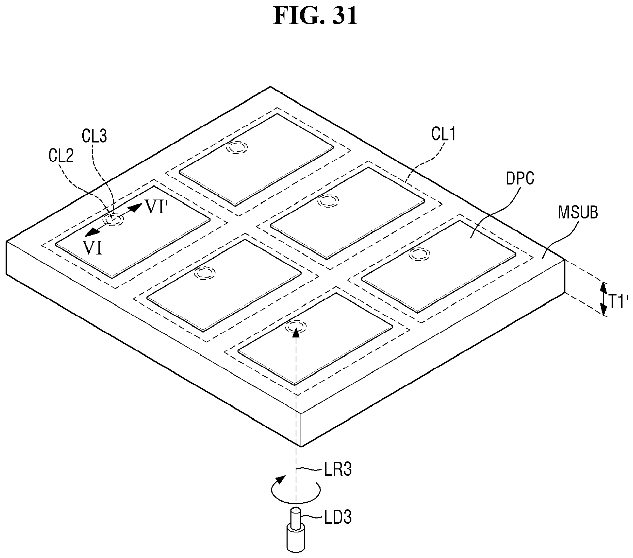

FIG. 23 is a flowchart for illustrating a method of fabricating a display device according to some embodiments of the present disclosure. FIGS. 24 to 39 are views for illustrating the method of fabricating a display device according to some embodiments of the present disclosure.

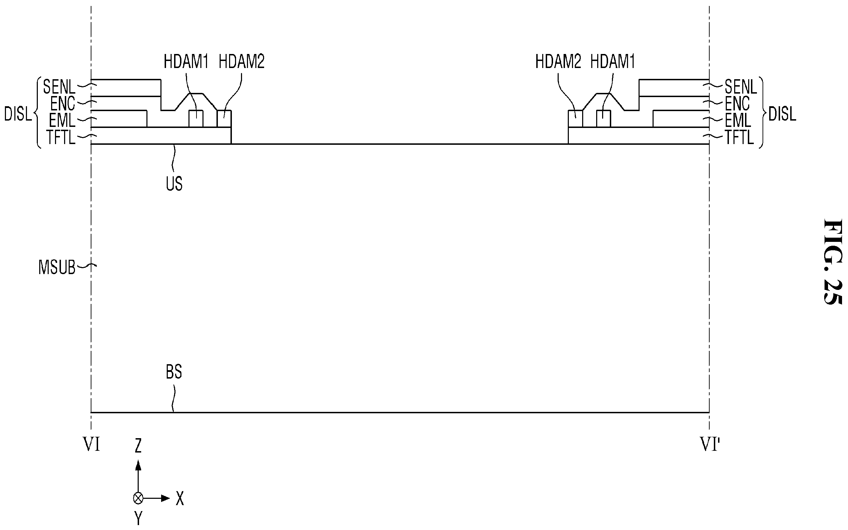

Firstly, as shown in FIGS. 24 and 25, a plurality of display cells DPC is formed on a first surface of a mother substrate MSUB (S110 of FIG. 23).

A display layer DISL of each of the plurality of display cells DPC is formed on the first surface of the mother substrate MSUB. The display layer DISL includes a thin-film transistor layer TFTL, a light emitting element layer EML, an encapsulation layer ENC, and a sensor electrode layer SENL.

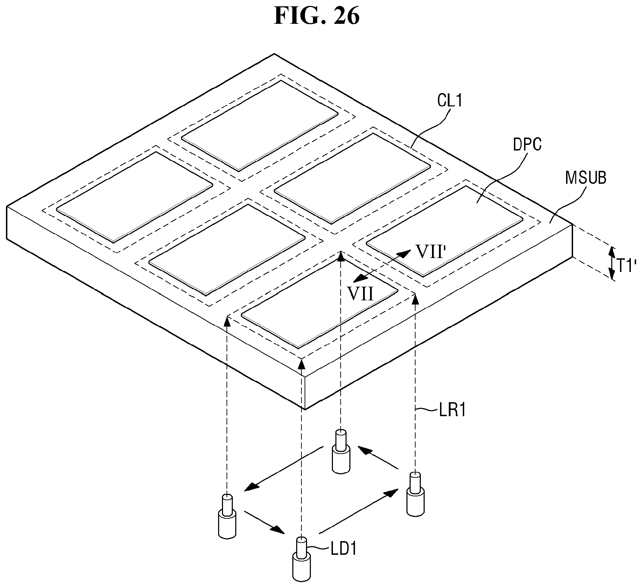

Secondly, as shown in FIG. 26, a plurality of first protective films PRF1 is attached on the plurality of display cells DPC, and the plurality of display cells DPC are inspected (S120 of FIG. 23).

Initially, a first protective film layer is attached to cover the plurality of display cells DPC and the mother substrate MSUB between the plurality of display cells DPC. Then, by partially removing the first protective film layer located on the mother substrate MSUB, the plurality of first protective films PRF1 may be located on the plurality of display cells DPC, respectively. That is to say, the first protective film layer may be partially removed, and the remaining portions may be the plurality of first protective films PRF1. Therefore, the plurality of first protective films PRF1 may be respectively located on the plurality of display cells DPC. In other words, the number of first protective films PRF1 may be equal to the number of the plurality of display cells DPC.

Each of the plurality of first protective films PRF1 may be a buffer film for protecting the display cells DPC from external shock. The plurality of first protective films PRF1 may be made of a transparent material.

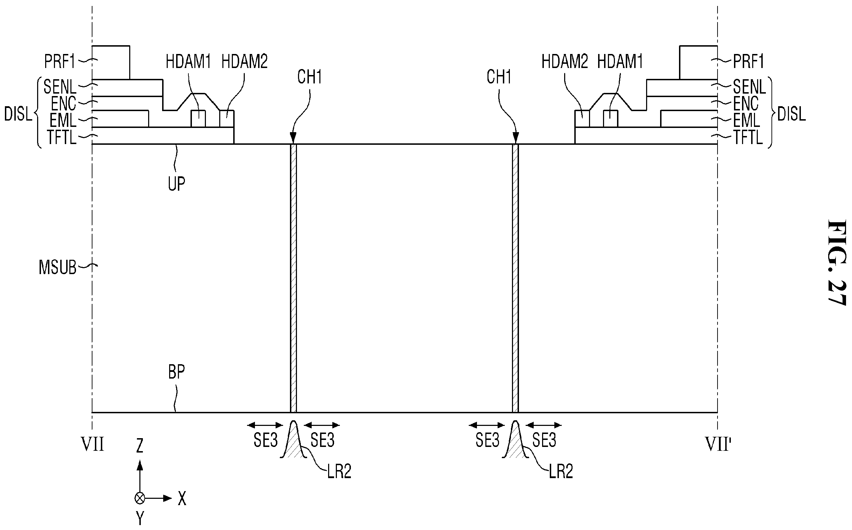

Thirdly, as shown in FIGS. 26 and 27, a first laser LR1 is irradiated onto the second surface of the mother substrate MSUB, so that a plurality of first laser irradiation areas CH1 is formed along edges of the plurality of display cells DPC (S130 of FIG. 23).

Any of a variety of lasers may be used as the first laser LR1 according to some embodiments of the present disclosure. Herein, the first laser LR1 is an infrared, Bessel beam having a wavelength of approximately 1,030 nm as an example.

A first cutting line CL1 may be defined as an imaginary line formed by connecting the plurality of first laser irradiation areas CH1. The first cutting line CL1 may be formed by irradiating the first laser LR1 to form the plurality of first laser irradiation areas CH1 along the edges of the plurality of display cells DPC.

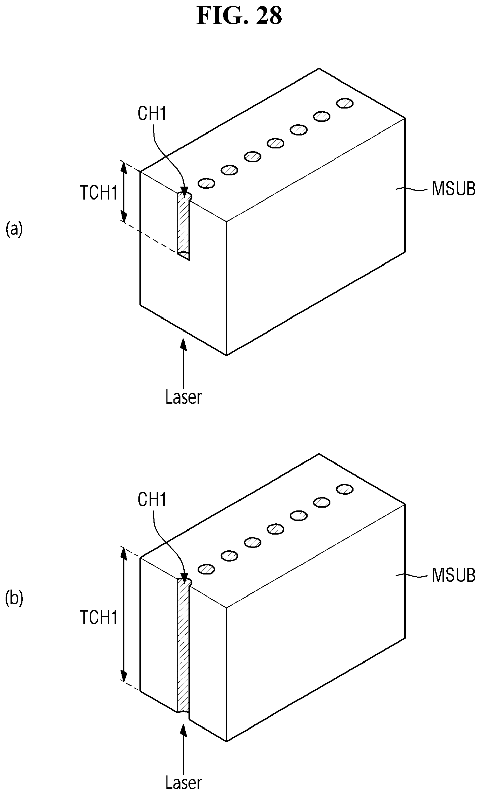

When the first laser LR1 is irradiated on the second surface of the mother substrate MSUB, the depth (or sketch length) TCH1 of each of the plurality of first laser irradiation areas CH1 formed by the first laser LR1 can be adjusted by adjusting the repetition rate, processing speed, and pulse energy, as shown in FIG. 28. For example, the depth TCH1 of each of the plurality of first laser irradiation areas CH1 may be at least 200 µm from the first surface of the mother substrate MSUB as shown in FIG. 28A. In addition, since the thickness of the mother substrate MSUB is approximately 500 µm, the depth TCH1 of each of the plurality of first laser irradiation areas CH1 may be up to 500 µm as shown in FIG. 28B. That is to say, the depth TCH1 of each of the plurality of first laser irradiation areas CH1 may be approximately 225 µm to 500 µm from the first surface of the mother substrate MSUB. According to some embodiments, the depth TCH1 of the first laser irradiation areas CH1 is equal to the thickness of the mother substrate MSUB.

The first laser LR1 for forming the first laser irradiation areas CH1 may be irradiated with a repetition rate of 10 kHz to 250 kHz, a processing speed of 10 mm/s to 250 mm/s, and a pulse energy of 10 µJ to 300 µJ. In order for the first laser LR1 to have a depth of approximately 225 µm from the first surface of the mother substrate MSUB, it is desired that it is irradiated with a repetition rate of approximately 17.5 kHz to 125 kHz, a processing speed of 17.5 mm/s to 125 mm/s, and a pulse energy of 25 µJ to 178 µJ.

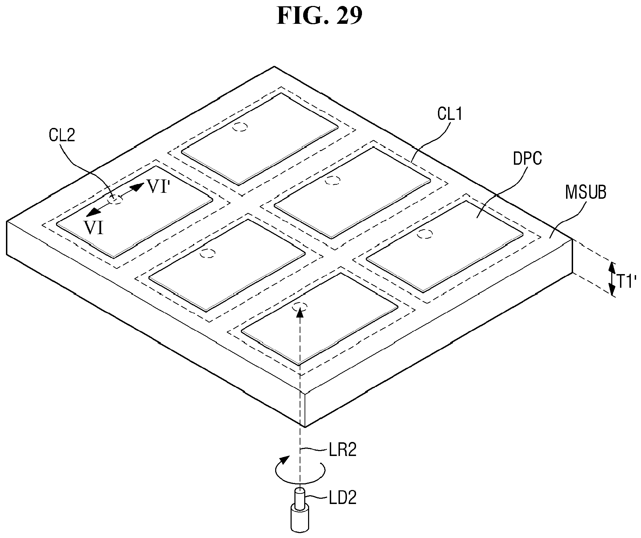

Fourthly, as shown in FIGS. 29 to 32, by irradiating a second laser LR2 and a third laser LR3 on the second surface of the mother substrate MSUB, a plurality of second laser irradiation areas CH2 and third laser irradiation areas CH3 for forming a through hole in each of the plurality of display cells are formed (S140 of FIG. 20).

Although step S140 is performed after step S130 is performed in the example shown in FIG. 29, the embodiments of the present disclosure are not limited thereto. In order to shorten the process time, steps S130 and S140 may be formed simultaneously with a plurality of laser modules.

A second cutting line CL2 may be defined as an imaginary line formed by connecting the plurality of second laser irradiation areas CH2. The second cutting line CL2 may be formed by irradiating the second laser LR2 to form the plurality of second laser irradiation areas CH2 along the edge of the through hole TH. The second cutting line CL2 may depend on the shape of the through hole. For example, when the through hole TH has a circular shape when viewed from the top, the second cutting line CL2 may be formed in a circular shape.

A third cutting line CL2 may be defined as an imaginary line formed by connecting the plurality of third laser irradiation areas CH3. The third cutting line CL3 may be formed by irradiating the third laser LR3 to form the plurality of third laser irradiation areas CH3 along the edge of the second cutting line CL2. The third cutting line CL3 may depend on the shape of the through hole. For example, when the through hole TH has a circular shape when viewed from the top, the third cutting line CL3 may be formed in a circular shape.

Any of a variety of lasers may be used as the second laser LR2 and the third laser LR3 according to some embodiments of the present disclosure. Herein, each of the second laser LR2 and the third laser LR3 is an infrared, Bessel beam having a wavelength of approximately 1,030 nm as an example.

The depth of each of the second laser irradiation areas CH1 formed by the second laser LR2 may be different from the depth (sketch length) of each of the second laser irradiation areas CH2 formed by the third laser LR3. The depth of the second laser irradiation areas CH2 may be defined as the depth (or sketch length) of the second laser irradiation areas CH2, and the depth of the third laser irradiation areas CH3 may be defined as the depth (or sketch length) of the third laser irradiation areas CH3.

Each of the plurality of second laser irradiation areas CH2 may have a depth of about 500 µm from the first surface of the mother substrate MSUB. Since the thickness of the mother substrate MSUB is approximately 500 µm, each of the plurality of second laser irradiation areas CH2 may have a depth of approximately 500 µm from the first surface of the mother substrate MSUB. That is to say, the depth of each of the plurality of second laser irradiation areas CH2 may be equal to the thickness of the mother substrate MSUB.

Each of the plurality of third laser irradiation areas CH3 may have a depth of approximately 225 µm from the first surface of the mother substrate MSUB. Since the thickness of the mother substrate MSUB is approximately 500 µm, each of the plurality of third laser irradiation areas CH3may have a depth of approximately 200 µm to 500 µm from the first surface of the mother substrate MSUB. According to some embodiments of the present disclosure, the depth of the second laser irradiation areas CH2 from the first surface of the mother substrate MSUB may be greater than the depth of the third laser irradiation areas CH3 from the first surface of the mother substrate MSUB.

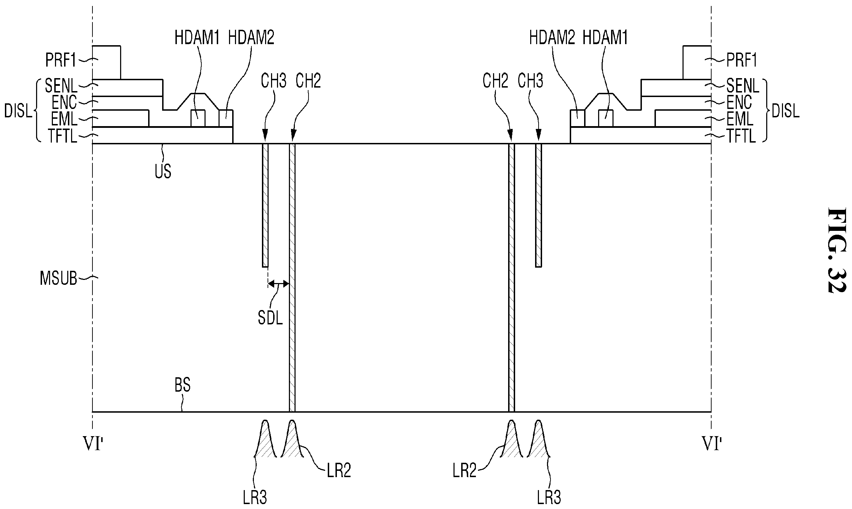

As shown in FIG. 32, the depth (or sketch length) of the laser irradiation areas may be adjusted according to the repetition rate, processing speed and pulse energy of the second laser LR2 and the third laser LR3. If the depth (or sketch length) of the second laser irradiation areas CH2 formed by the second laser LR2 is different from the depth (or sketch length) of the third laser irradiation areas CH3 formed by the third laser LR3, the second laser LR2 and the third laser LR3 have different repetition rate, processing speed, pulse energy, etc.

For example, the second laser LR2 may be irradiated with a repetition rate of 1 kHz to 50 kHz, a processing speed of 1 mm/s to 50 mm/s, and a pulse energy of 10 µJ to 300 µJ. In order for the second laser LR2 to have a depth of approximately 400 µm to 500 µm from the first surface of the mother substrate MSUB, it may be irradiated with a repetition rate of approximately 10kHz, a processing speed of 10 mm/s, and a pulse energy of 60 µJ to 178 µJ.

For example, the third laser LR3 may be irradiated with a repetition rate of 10 kHz to 250 kHz, a processing speed of 10 mm/s to 250 mm/s, and a pulse energy of 10 µJ to 300 µJ. In order for the third laser LR3 to have a depth of approximately 225 µm or higher from the first surface of the mother substrate MSUB, it is desired that it is irradiated with a repetition rate of approximately 17.5 kHz to 125 kHz, a processing speed of 17.5 mm/s to 125 mm/s, and a pulse energy of 25 µJ to 178 µJ.

The unilateral tolerance of each of the second laser LR2 and the third laser LR3 may be within approximately 50 µm, and the bilateral tolerance may be within approximately 100 µm. Herein, the unilateral tolerance may refer to a cutting error in a direction (e.g., x-axis direction) when laser irradiation areas are formed with lasers.

In addition, the spacing between the second laser irradiation area CH2 formed by the second laser LR2 and the third laser irradiation area CH3 formed by the third laser LR3 may be approximately 50 µm. The spacing between the second laser irradiation area CH2 and the third laser irradiation area CH3 may determine lengths of the first surface IS1 and the second surface IS2 of the substrate SUB. For example, as the spacing between the second laser irradiation area CH2 and the third laser irradiation area CH3 increases, the length of the second surface IS2 in the inclination direction may become larger than the length of the first surface IS1 in the inclination direction.

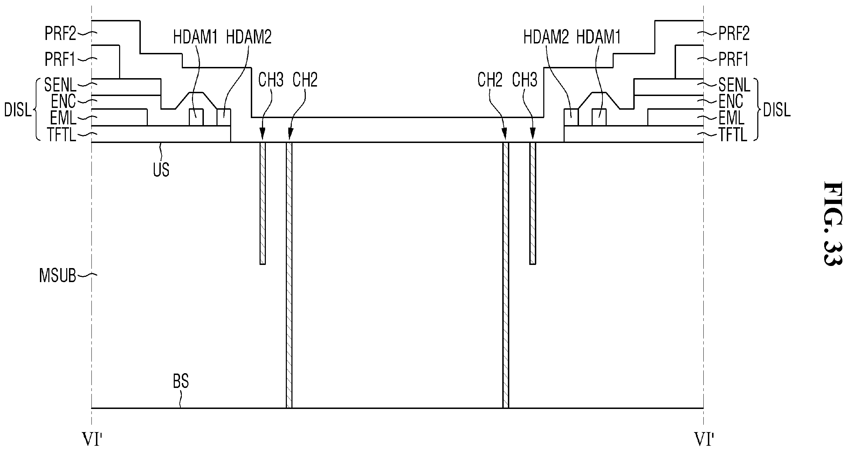

Fifthly, as shown in FIG. 33, a second protective film PRF2 is attached on the plurality of first protective films PRF1 as shown in FIG. 33 (S150 of FIG. 20).

The second protective film PRF2 may be attached on the plurality of first protective films PRF1 and the exposed portion of the mother substrate MSUB without being covered by the plurality of first protective films PRF1. The second protective film PRF2 may cover the plurality of first laser irradiation areas CH1, the plurality of second laser irradiation areas CH2 and the plurality of third laser irradiation areas CH3. The second protective film PRF2 may be an acid-resistant film for protecting the plurality of display cells DPC from an etchant in a subsequent process of etching the mother substrate MSUB.

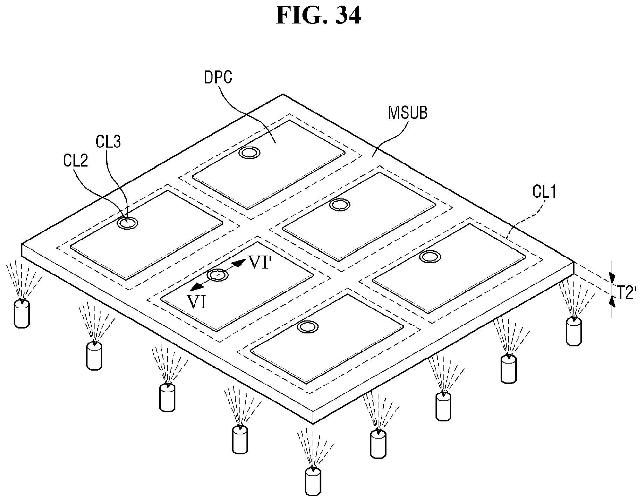

Sixthly, as shown in FIGS. 34 to 37, the etchant is sprayed on the second surface of the mother substrate MSUB without additional mask so that the thickness of the mother substrate MSUB is reduced. In addition, the mother substrate is cut along the plurality of first laser irradiation areas CH1, the second laser irradiation areas CH2 and the third laser irradiation areas CH3, and the second protective film PRF2 is detached (S160 of FIG. 23).

When the etchant is sprayed on the second surface of the mother substrate MSUB, the mother substrate MSUB may be reduced from a first thickness T1' (see FIG. 24) to a second thickness T2'. Since the mother substrate MSUB is etched without additional mask, the mother substrate MSUB may be etched uniformly over the entire area of the second surface.

Each of the first laser irradiation areas CH1 may include a physical hole formed by the first laser LR1 and a region in which physical properties are changed by the laser as a periphery of the physical hole. Alternatively, each of the plurality of first laser irradiation areas CH1 may be an area in which the physical properties are changed by the first laser LR1 without a physical hole. Accordingly, the etch rate in each of the plurality of first laser irradiation areas CH1 by the etchant may be higher than the etch rate in the other areas of the mother substrate MSUB where the laser is not irradiated.

Each of the second laser irradiation areas CH2 may include a physical hole formed by the second laser LR2 and a region in which physical properties are changed by the laser as a periphery of the physical hole. Alternatively, each of the plurality of second laser irradiation areas CH2 may be an area in which the physical properties are changed by the second laser LR2 without a physical hole. Accordingly, the etch rate in each of the plurality of second laser irradiation areas CH2 by the etchant may be higher than the etch rate in the other areas of the mother substrate MSUB where the laser is not irradiated.

Each of the third laser irradiation areas CH3 may include a physical hole formed by the third laser LR3 and a region in which physical properties are changed by the laser as a periphery of the physical hole. Alternatively, each of the plurality of third laser irradiation areas CH3 may be an area in which the physical properties are changed by the third laser LR3 without a physical hole. Accordingly, the etch rate in each of the plurality of third laser irradiation areas CH3 by the etchant may be higher than the etch rate in the other areas of the mother substrate MSUB where the laser is not irradiated.

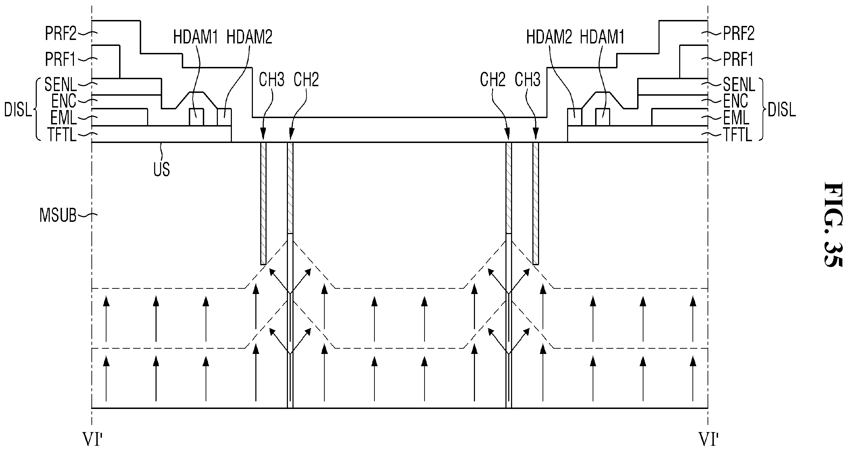

As shown in FIG. 35, slimming is carried out to reduce the thickness of the mother substrate MSUB with the etchant. At the same time, the etchant permeates into the plurality of second laser irradiation areas CH2 formed by the second laser LR2. Since the depth of each of the plurality of second laser irradiation areas CH2 is greater than the depth of each of the plurality of third laser irradiation areas CH3, the etchant may first permeates into the plurality of second laser irradiation areas CH2. When the etchant permeates into the second laser irradiation areas CH2, there may be a difference in the etch rate between the second laser irradiation areas CH2 and the areas where the second laser irradiation areas CH2 are not formed. As a result, slimming may be carried out with inclination in the vicinity of the second laser irradiation areas CH2.

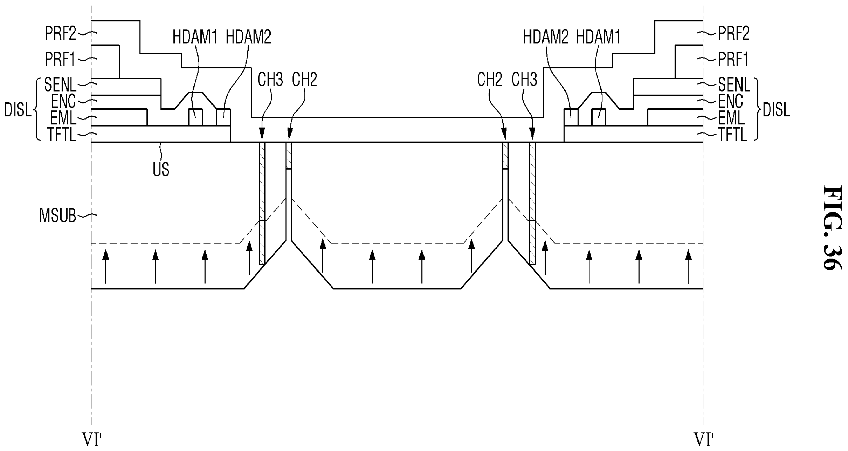

As shown in FIG. 36, when the etchant permeates into the third laser irradiation areas CH3, there may be a difference in the etch rate between the third laser irradiation areas CH3 and the areas where the third laser irradiation areas CH3 are not formed. In particular, there may be a difference in the etch rate between the third laser irradiation areas CH3 and the second laser irradiation areas CH2. Accordingly, the slimming is performed with inclination in the vicinity of the second laser irradiation areas CH2 and the third laser irradiation areas CH3. The slimming may be performed as the inclination may be reduced at some areas between the third laser irradiation areas CH3 and the second laser irradiation areas CH2.

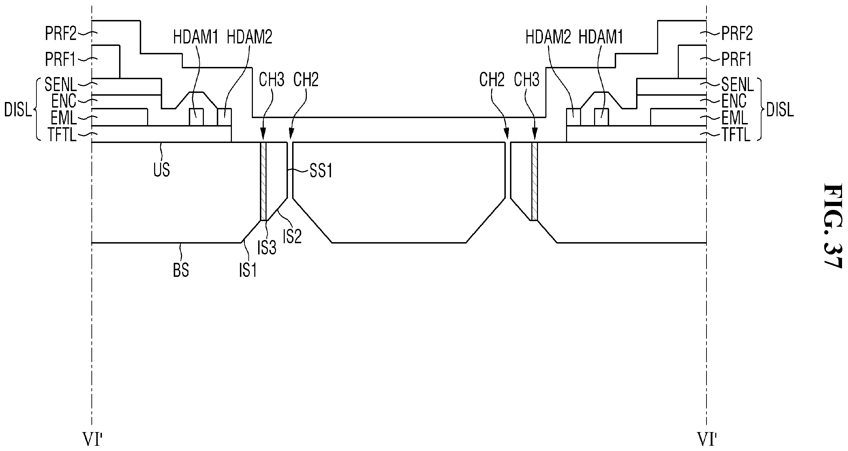

As shown in FIG. 37, since etching is carried out first in the second laser irradiation areas CH2, the substrate SUB may be cut at the second cutting line CL2 formed by the second laser irradiation areas CH2 so that it can be separated from the mother substrate MSUB. Accordingly, the substrate SUB may form a through hole TH, and there may be steps between the side surface SS1 and the bottom surface BS in the through hole TH, so that the first surface IS1, the second surface IS2 and the third surface IS3 between the first surface IS2 and the second surface IS2 may be formed.

In addition, as the etchant permeates into the plurality of first laser irradiation areas CH1 formed by the first laser LR1, the mother substrate MUSB may be separated along the first cutting line CL1. In other words, each of the plurality of display cells DPC may be separated from the mother substrate MSUB.

Since the etchant does not permeate into the first surface of the substrate SUB separated from the mother substrate MSUB due to the second protective film, whereas the second surface of the substrate SUB is etched by the etchant. Accordingly, the first surface and the second surface of the substrate SUB may have differences in roughness, hardness, light transmittance, light reflectance, local density, surface chemical structure, etc.

After the etching process is completed, the second protective film PRF2 may be detached.

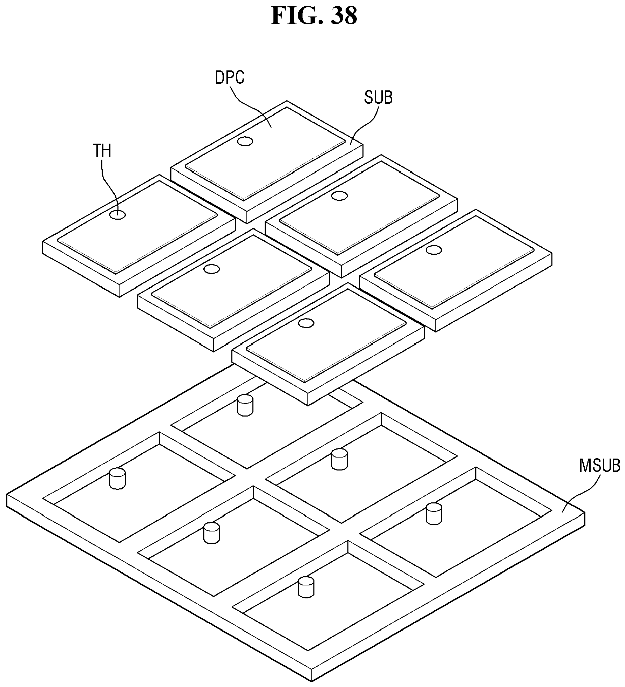

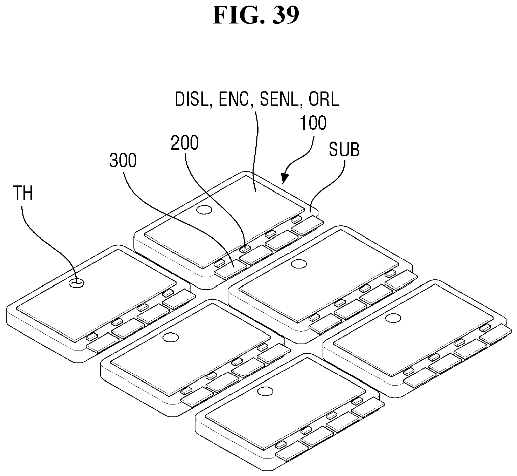

Seventhly, as shown in FIGS. 38 and 39, driving ICs 200 and circuit boards 300 are attached to each of the plurality of display cells DPC, and the first protective film PRF1 is detached from each of the plurality of display cells DPC (S170 of FIG. 23).

As described above, by using the etching process, the thickness of the mother substrate MSUB can be reduced, the substrate SUB of each of the plurality of display cells DPC can be separated from the mother substrate MSUB, and the through hole TH can be formed. In this manner, it may be possible to increase the efficiency of the fabricating process.

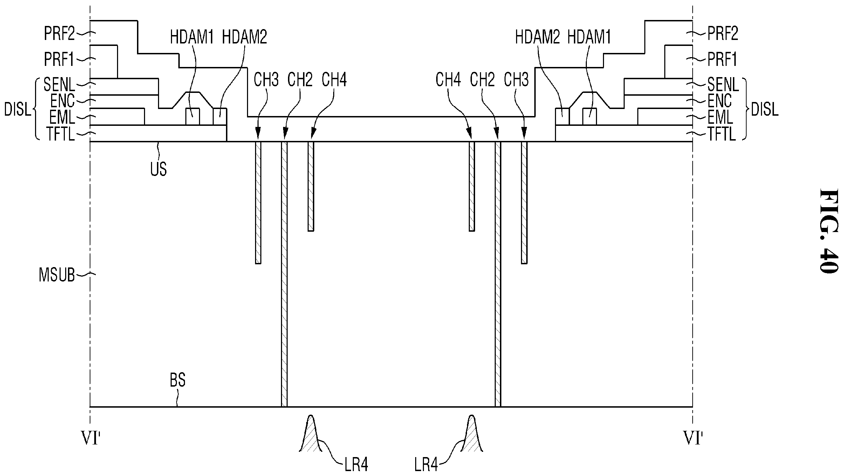

FIGS. 40 to 42 are cross-sectional views for illustrating a method of fabricating a display device according to some embodiments of the present disclosure.

Referring to FIGS. 40 to 42, according to some embodiments, after irradiating the above-described second laser LR2 and third laser LR3, fourth laser irradiation areas CH4 may be further formed by irradiating a fourth laser LR4.

The fourth laser LR4 may be irradiated adjacent to the second laser irradiation areas CH2 between the third laser irradiation area CH3. When the through hole TH of the fourth laser LR4 has a circular shape when viewed from the top, the fourth laser irradiation areas CH4 formed by the fourth laser LR4 may have a circular shape when viewed from the top. The fourth laser LR4 may be an infrared, Bessel beam having a wavelength of approximately 1,030 nm like the third laser LR3, and may be irradiated under the same conditions as the third laser LR3.

The depth of the fourth laser irradiation areas CH4 formed by the fourth laser LR4 may be smaller than the depth of the third laser irradiation areas CH3. This is because if the depth of the fourth laser irradiation areas CH4 is relatively large, the substrate SUB may be cut at the fourth laser irradiation areas CH4.

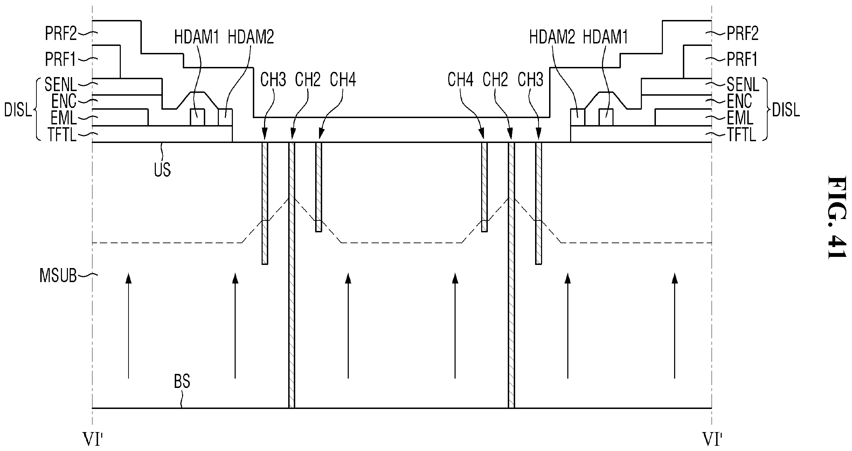

As shown in FIG. 41, when the etchant permeates into the fourth laser irradiation areas CH4, there may be a difference in the etch rate between the fourth laser irradiation areas CH4 and the areas where the fourth laser irradiation areas CH4 are not formed. In particular, there may be a difference in the etch rate between the fourth laser irradiation areas CH4 and the second laser irradiation areas CH2. Accordingly, the slimming is performed with inclination in the vicinity of the fourth laser irradiation areas CH4. The slimming may be performed as there is substantially no inclination between the fourth laser irradiation areas CH4 and the second laser irradiation areas CH2.

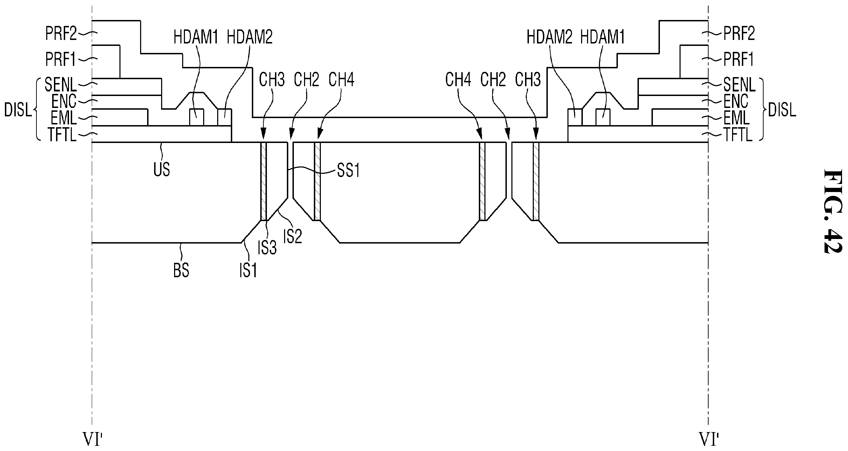

As shown in FIG. 42, since etching is carried out first in the second laser irradiation areas CH2, the substrate SUB may be cut at the second cutting line CL2 formed by the second laser irradiation areas CH2 so that it can be separated from the mother substrate MSUB. The side surface of the mother substrate MSUB where the through hole TH is formed forms a stepped edge like the substrate SUB. The stepped edge of the side surface of the mother substrate MSUB can reduce the angle of the edge of the mother substrate MSUB and can increase the width of the stepped edge. Accordingly, when the mother substrate MSUB is separated from the substrate SUB, the through hole TH has a larger width so that it can be separated more easily.

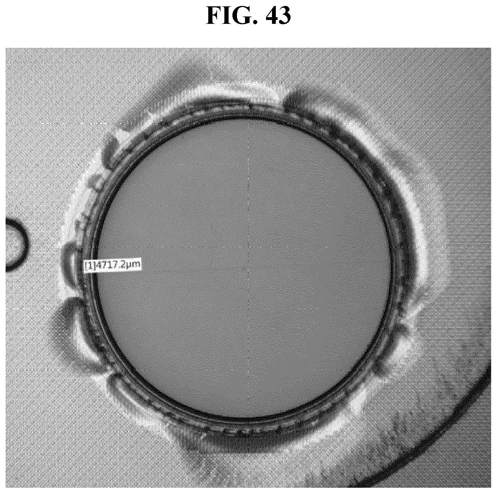

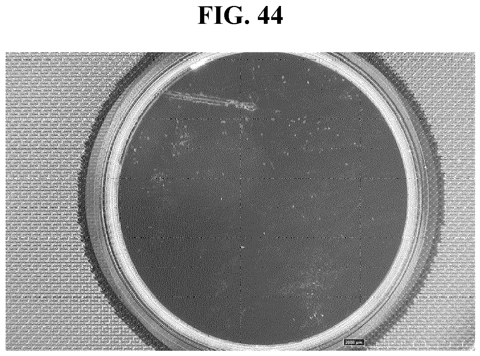

FIG. 43 is an image showing a through hole of a display device according to Comparative Example. FIG. 44 is an image showing a through hole of a display device according to some embodiments of the present disclosure.

FIG. 43 shows a through hole formed via a laser ablation process. FIG. 44 shows a through hole formed by the above-described laser irradiation and etchant.

It can be seen from FIG. 43 that the display device according to Comparative Example was damaged by high heat in the vicinity of the through hole TH. In contrast, as shown in FIG. 44, in the display device according to some embodiments, almost no damage occurred in the vicinity of the through hole TH.

In view of the above, it may be possible to prevent or reduce the display device according to some embodiments from being damaged in the vicinity of the through hole by way of forming the through hole using laser irradiation and etchant.

In concluding the detailed description, those skilled in the art will appreciate that many variations and modifications can be made to the example embodiments without substantially departing from the principles of the present invention. Therefore, the disclosed example embodiments of the invention are used in a generic and descriptive sense only and not for purposes of limitation.

## Claims

1. A display device (10) comprising:
a substrate (SUB) comprising an upper surface (US), a bottom surface (BS) facing the upper surface (US), and a through hole (TH) penetrating the upper surface (US) and the bottom surface (BS); and
a light emitting element layer (EML) on the upper surface (US) of the substrate (SUB),
wherein the substrate (SUB) comprises a side surface (SS1) that meets the upper surface (US) in the through hole (TH), a first surface (IS1) that meets the bottom surface (BS), a second surface (IS2) that meets the side surface (SS1), and a third surface (IS3) between the first surface (IS1) and the second surface (IS2), and
wherein the first surface (IS1) and the second surface (IS2) are spaced apart from each other with the third surface (IS3) therebetween, and are inclined surfaces.

2. The display device (10) of claim 1, wherein one end of the third surface (IS3) meets the first surface (IS1) and an opposite end of the third surface (IS3) meets the second surface (IS2).

3. The display device (10) of claim 1 or 2, wherein an angle (θ5) between the bottom surface (BS) and the first surface (IS1) and an angle between the side surface (SS1) and the second surface (IS2) are obtuse angles.

4. The display device (10) of claim 1 or 2, wherein an angle (θ5) between the bottom surface (BS) and the first surface (IS1) is equal to an angle between the side surface (SS1) and the second surface (IS2).

5. The display device (10) of claim 1 or 2, wherein an angle (θ5) between the bottom surface (BS) and the first surface (IS1) is greater than an angle between the side surface (SS1) and the second surface (IS2).

6. The display device (10) of claim 1 or 2, wherein an angle between the side surface (SS1) and the second surface (IS2) is greater than an angle (θ5) between the bottom surface (BS) and the first surface (IS1).

7. The display device (10) of at least one of claims 1 to 6, wherein a length of the first surface (IS1) in an inclined direction is equal to a length of the second surface (IS2) in an inclined direction.

8. The display device (10) of at least one of claims 1 to 7, wherein a length of the first surface (IS1) in an inclined direction is greater than a length of the second surface (IS2) in an inclined direction.

9. The display device (10) of at least one of claims 1 to 7, wherein a length of the second surface (IS2) in an inclined direction is greater than a length of the first surface (IS1) in an inclined direction.

10. The display device (10) of at least one of claims 1 to 9, wherein the third surface (IS3) extends in parallel to the bottom surface (BS) or the upper surface (US).

11. The display device (10) of at least one of claims 1 to 9, wherein the third surface (IS3) is an inclined surface.

12. The display device (10) of at least one of claims 1 to 11, wherein at least one of the first surface (IS1) or the second surface (IS2) is a straight surface or a curved surface.

13. The display device (10) of at least one of claims 1 to 12, wherein a length on a plane formed by the first surface (IS1), the second surface (IS2) and the third surface (IS3) between the bottom surface (BS) and the side surface (SS1) is 100 µm to 500 µm.

14. The display device (10) of at least one of claims 1 to 9 or 11 to 13, wherein the bottom surface (BS) and the third surface (IS3) form a stepped edge.

15. The display device of claim 14, further comprising: an optical device (OPD) at least partially inserted into the through hole (TH).

16. A method of fabricating a display device (10), in particular a display device of at least one of claims 1 to 15, the method comprising:
forming a plurality of display cells (DPC) on a first surface (IS1) of a mother substrate (MSUB);
forming first laser irradiation areas (CH1) for cutting the plurality of display cells (DPC) by irradiating a first laser on a second surface (IS2) facing the first surface (IS1) of the mother substrate (MSUB);
irradiating a second laser and a third laser on the first surface (IS1) of the mother substrate (MSUB) to form second laser irradiation areas (CH2) and third laser irradiation areas (CH3) along an edge of a through hole (TH) of each of the plurality of display cells (DPC); and
separating the plurality of display cells (DPC) by spraying an etchant on the second surface (IS2) of the mother substrate (MSUB) and cutting the mother substrate (MSUB) along the first laser irradiation areas (CH1) and the second laser irradiation areas (CH2) of the mother substrate (MSUB).

17. The method of claim 16, wherein the third laser irradiation areas (CH3) surround the second laser irradiation areas (CH2).

18. The method of claim 16 or 17, wherein a depth of the second laser irradiation areas (CH2) from the first surface (IS1) of the mother substrate (MSUB) is greater than a depth of the third laser irradiation areas (CH3) from the first surface (IS1) of the mother substrate (MSUB).

19. The method of at least one of claims 16 to 18, wherein a repetition rate of the first laser and the third laser ranges from 10 kHz to 250 kHz, and a repetition rate of the second laser ranges from 1 kHz to 50 kHz.

20. The method of at least one of claims 16 to 19, wherein a processing speed of the first laser and the third laser ranges from 10 mm/s to 250 mm/s, and a processing speed of the second laser ranges from 1 mm/s to 50 mm/s.

21. The method of at least one of claims 16 to 20, wherein a pulse energy of the first laser and the third laser and a pulse energy of the second laser range from 10 µJ to 300 µJ.

22. The method of at least one of claims 16 to 21, further comprising: forming fourth laser irradiation areas (CH4) by irradiating a fourth laser along an edge of the through hole (TH) at locations spaced apart from and on an inner side of the second laser irradiation areas (CH2).
